**Europäisches Patentamt**

**European Patent Office**

**Office européen des brevets**

(11) Publication number: **0 060 657**
**B1**

## (12) EUROPEAN PATENT SPECIFICATION

(45) Date of publication of patent specification: **04.07.90**

(21) Application number: **82301126.7**

(22) Date of filing: **05.03.82**

(51) Int. Cl.⁵: **H 01 L 31/10, H 01 L 29/36, H 01 L 27/14, G 11 C 17/00, G 11 C 11/34**

(54) **High electron mobility heterojunction semiconductor devices.**

(30) Priority: **06.03.81 JP 32088/81**

(43) Date of publication of application:
**22.09.82 Bulletin 82/38**

(45) Publication of the grant of the patent:
**04.07.90 Bulletin 90/27**

(84) Designated Contracting States:
**DE FR GB NL**

(56) References cited:
**US-A-3 448 348**
**US-A-4 295 002**

**APPLIED PHYSICS LETTERS, vol.33, no.7, October 1978, New York, US, R. DINGLE et al.:"Electron mobilities in modulation-doped semiconductor heterojunction superlattics", pages 665-667**

**JAPANESE JOURNAL OF APPLIED PHYSICS, vol. 19, no. 5, May 1980 (letter S), Tokyo, JP, T. MIMURA et al.:"A new field-effect transistor with selectively doped GaAs/n-AlxGa1-xAs heterojunctions", pages L225-L227**

(73) Proprietor: **FUJITSU LIMITED**
**1015, Kamikodanaka Nakahara-ku Kawasaki-shi Kanagawa 211 (JP)**

(72) Inventor: **Okamura, Shigeru**
**1-9-503, Fujinodaidanchi 3486, Honmachida Machida-shi Tokyo 194 (JP)**
Inventor: **Ishikawa, Tomonori**
**4-2-13, Fujigaya Kugenuma Fujisawa-shi Kanagawa 251 (JP)**

(74) Representative: **Sunderland, James Harry et al HASELTINE LAKE & CO Hazlitt House 28 Southampton Buildings Chancery Lane London WC2A 1AT (GB)**

(56) References cited:
**APPLIED PHYSICS LETTERS, vol.37, no.9, November 1980, New York, US, S. HIYAMIZU et al.:"High mobility of two-dimensional electrons at the GaAs/n-AlGaAs heterojunction interface", pages 805-807**

Courier Press, Leamington Spa, England.

(56) References cited:

APPLIED PHYSICS LETTERS, vol.37, no.11, December 1980, New York, US, L. C. WITKOWSKI et al.:"High mobilities in AlxGa1-xAs-GaAs heterojunctions", pages 1033-1035

ELECTRONICS LETTERS, vol. 17, no. 10, May 14, 1981, London, GB, P. DELESCLUSE et al.:"Transport properties in GaAs-AlxGa1-xAs heterostructures an MESFET application", pages 342-344

IBM TECHNICAL DISCLOSURE BULLETIN, vol. 15, no. 4, September 1972, New York, US, S.C.C. TSENG et al.:"Electrooptical memory with write, read and erase characteristics", pages 1327-1328

# EP 0 060 657 B1

**Description**

This invention relates to semiconductor devices of which the conductive channel consists of electrons accumulated in the neighborhood of a heterojunction between a pair of layers, the layers being of semiconductors having different electron affinities, as a result of the difference in electron affinities, the accumulated electrons having a large electron mobility (such devices are herein referred to as high electron mobility heterojunction semiconductor devices).

A high electron mobility heterojunction semiconductor device is either an active or a passive semiconductor device the conductive channel of which consists not of carriers contained in one or more bulk semiconductors but of electrons (hereinafter referred to as a two-dimensional electron gas) accumulated in a (quasi-) two-dimensional surface contiguous with a heterojunction between a layer of a semiconductor having a lesser electron affinity (e.g. AlGaAs) and another layer of a semiconductor having a greater electron affinity (e.g. GaAs). Since the layer of a semiconductor having a lesser electron affinity is responsible for supply of electrons to the two-dimensional electron gas, that layer will be hereinafter referred to as an electron source layer. Since the layer of a semiconductor having a greater electron affinity is responsible for allowing electrons to accumulate therein, for the ultimate purpose of providing such a layer configuration with a channel or such a two-dimensional electron gas, the layer will be hereinafter referred to as a channel layer.

The outstanding feature of electrons accumulated in a two-dimensional surface contiguous with a heterojunction between an electron source layer of a semiconductor having a lesser electron affinity (e.g. AlGaAs) and a channel layer of a semi-conductor having a greater electron affinity (e.g. GaAs), is an extremely large electron mobility which becomes available therefor at a cryogenic temperature within the temperature range not exceeding 150°K. The thickness of the two-dimensional electron gas which accumulates in the channel layer of e.g. GaAs, in the form of plane or surface contiguous with the heterojunction, is extremely small, specifically less than 100 angstroms. Therefore, the two-dimensional electron gas has a geometrical position separated from the electron source layer of e.g. AlGaAs. As a result, the mobility of the electrons constituting the two-dimensional electron gas becomes free from the effects of ionized-impurity scattering caused by the impurities contained in layers contiguous therewith.

It is well-known that ionized-impurity scattering is the major factor limiting electron mobility in the cryogenic temperature range. Since the mobility of the electrons constituting the two-dimensional electron gas is free from the effects of ionized-impurity scattering, as described above, the two-dimensional electron gas turns out to have an extremely large electron mobility at any temperature in the cryogenic temperature range in which ionized-impurity scattering is inherently the major factor limiting electron mobility. Results of experiments show that the magnitude of this improvement in electron mobility is a factor of more than 10 and electron mobilities of $1.5 \times 10^5$ cm²/VS and $5 \times 10^5$ cm²/VS respectively at 77°K and 5°K have been determined for one example consisting of an undoped GaAs channel layer and an n type AlGaAs electron source layer.

Applied Physics Letters, Vol. 37, No. 9, pages 805 to 807, Hiyamizu et al., discusses the temperature dependence of electron mobility in heterojunction devices.

The requirements which semiconductors must satisfy if a two-dimensional electron gas is to accumulate between layers thereof are (1) identity or resemblance of the lattice constants of the semiconductors and (2) large difference between the electron affinities and band gaps of the semiconductors. A number of pairs of semiconductors are available which meet these requirements and some examples are tabulated below.

Semiconductor pairs allowing two-dimensional electron gas to accumulate therebetween

| Item | Semiconductors | Latice constant angstrom | Electron affinity eV |
|------|---------------|--------------------------|----------------------|
| 1. | AlGaAs | 5.657 | 3.77 |
|    | GaAs | 5.654 | 4.07 |
| 2. | AlGaAs | 5.657 | 3.77 |
|    | Ge | 5.658 | 4.13 |
| 3. | GaAs | 5.654 | 4.07 |
|    | Ge | 5.658 | 4.13 |
| 4. | CdTe | 6.477 | 4.28 |
|    | InSb | 6.479 | 4.59 |
| 5. | GaSb | 6.095 | 4.06 |
|    | InAs | 6.058 | 4.9 |

One example of an active high electron mobility heterojunction semiconductor device is a high electron mobility transistor (hereinafter referred to as a HEMT). Japanese Journal of Applied Physics, Vol. 19, No. 5, pages L225 to L227, Mimura et al., discloses a HEMT. Various passive high electron mobility heterojunction semiconductor devices can be provided, for example capacitors and connection channels produced, for instance, so as to be associated with one or more HEMTs produced in a substrate on which such capacitors and/or such connection channels are also produced.

One drawback that has been inherently associated with high electron mobility heterojunction semiconductor devices is that it has been impossible to adjust, revise, modify or modulate the characteristics of the devices because the characteristics are determined by the layer configuration of the device and the concentration of n type impurities contained in the electron source layer of the device, none of which factors can be adjusted, revised, modified or modulated once production of the device is finished.

The present invention provides for the adjustment, revision, modification or modulation of the charcteristics of high electron mobility semiconductor devices.

According to the present invention there is provided a method of modifying characteristics of a high electron mobility heterojunction semiconductor device having an electron source layer and a channel layer, which method involves increasing the surface concentration of electrons which are accumulated along the heterojunction of the device, by exposing the device maintained at low temperatures to electromagnetic radiation, in order to induce a modification of characteristics of the device such as electrical conductivity, threshold voltage, saturated source current, the said modification being maintainable after the exposure so long as the device remains at low temperatures.

The capability for such adjustment, revision, modification or modulation of the characteristics of a high electron mobility heterojunction semiconductor device is effective (1) to improve productivity, specifically production yield of devices, (2) to provide a high electron mobility heterojunction semiconductor device capable of adjustment, revision or modulation of the characteristics thereof, and (3) to provide for a diversification of the uses of high electron mobility heterojunction devices, particularly into the field of memory elements, specifically programmable memory elements, switching elements, sensing elements, et al.

Another drawback that has been inherently associated with high electron mobility heterojunction semiconductor devices is that the electron mobility of the two-dimensional electron gas is more or less influenced by an ionized impurity scattering phenomenon caused by ionized impurities existing in the neighbourhood of the heterojunction. On the other hand, some source of electrons which are free or which are not held by atoms is essential for the electron source layer, because the two-dimensional electron gas requires some quantity of electrons to move thereto from one of the semiconductor layers constituting a heterojunction along which the two-dimensional electron gas accumulates. In order to satisfy this requirement, the high electron mobility heterojunction semiconductor devices available in the prior art are provided with an electron source layer of a semiconductor having a lesser electron affinity and which contains n type impurity. Therefore, a potentially easy method of further increasing the electron mobility of the two-dimensional electron gas may be to increase the surface concentration of electrons which constitute the two-dimensional electron gas, because this is effective to increase the screening effects of the scattering potential of electrons, as a result decreasing the effects of ionized impurity scattering of the impurities contained in the semiconductor layers constituting the heterojunction around which the two-dimensional electron gas accumulates. Increase in the impurity concentration of the semiconductor of an electron source layer is effective to increase the surface concentration of electrons which constitute the two-dimensional electron gas. However, such an increase in impurity concentration is inevitably accompanied by an adverse effect due to some quantity of the impurities introduced into the electron source layer diffusing into the channel layer during thermal processes involved in subsequent steps for production of a high electron mobility heterojunction device, as a result increasing the effects of ionized impurity scattering caused by ionized impurities contained in the channel layer, ultimately offsetting the effects of the increased surface concentration of electrons which constitute the two-dimensional electron gas.

In attempts to overcome this drawback, some high electron mobility heterojunction semiconductor devices are provided with a buffer layer containing no impurities and which is produced of a semiconductor which is identical to that of the electron source layer. The thicker the buffer layer is, the greater the effect it has in inhibiting the diffusion of impurity to the channel layer. On the other hand, the larger the thickness of such a buffer layer the lesser are the effects of the potential gap caused by the difference in electron affinities (of the channel and source layers), resultantly decreasing the surface concentration of the two-dimensional electron gas.

This means that if it were possible to decrease the concentration of n-type impurities contained in the electron source layer without this decrease being accompanied by the adverse effect of a decrease in the surface concentration of electrons which constitute the two-dimensional electron gas, this would be effective to increase the electron mobility of the two-dimensional electron gas.

The present invention provides for a decrease in the impurity concentration of the electron source layer without a decrease in the surface concentration of electrons which constitute the two-dimensional electron gas of a high electron mobility heterojunction semiconductor device.

The present invention can provide a high electron mobility heterojunction semiconductor device the

EP 0 060 657 B1

characteristics of which can be modulated after the completion of the production thereof and the operation speed of which is increased.

According to the present invention there is provided a high electron mobility heterojunction semiconductor device, comprising a high electron mobility heterojunction semiconductor element having a pair of layers of which one is an electron source layer and the other, containing no impurities practically speaking and having an electron affinity larger than that of the electron source layer, is a channel layer, characterised in that at least a portion of the said pair of layers is arranged so as to be exposable to electromagnetic radiation, so that, by such exposure, the surface concentration of electrons which are accumulated along the heterojunction of the element is increased in order to induce a modification of characteristics of the element, such as electrical conductivity, threshold voltage, saturated source current, and in that a container contains the said pair of layers and is operable to maintain the contained layers at a temperature not exceeding 150K.

The present invention can also provide an active device, specifically a field effect transistor, belonging to the category of high electron mobility heterojunction semiconductor devices (or HEMT) the characteristics of which, specifically threshold voltage, saturated source drain current, et al, can be modified after completion of the production thereof and of which the operation speed is increased.

The present invention can further provide a passive device, specifically a connection channel or a capacitor, belonging to the category of high electron mobility heterojunction semiconductor devices, resistance of which is decreased.

The present invention can moreover provide a method for the modulation of characteristics of a high electron mobility heterojunction semiconductor device. Such modulation can be effected a plurality of times after completion of the production of the device.

The present invention can also provide a method for modulation of the characteristics, specifically threshold voltage, saturated source drain current, et al, of an HEMT provided with an insulated gate produced employing a transparent or translucent insulator. Such modulation can be effected a plurality of times after completion of production of the device.

The present invention can further provide a programmable memory device provided with one or more high electron mobility heterojunction semiconductor devices.

The present invention can moreover provide a programmable memory device wherein writing and reading are effected by employment of electromagnetic waves.

The present invention can also provide equipment for sensing an image, the equipment consisting of a plurality of high electron mobility heterojunction semiconductor device.

The present invention provides, in relation to high electron mobility heterojunction semiconductor devices, for the adjustment, revision or modulation of characteristics thereof, it being possible to carry out the adjustment, revision of modulation even after completion of the production thereof or after the semiconductor devices are put to practical use. Thereby, the present invention provides such semiconductor devices with great flexibility and significant diversification of the uses to which they can be put. For example such devices can, by virtue of the present invention, be employed in the field of memory elements, and the present invention provides methods for employment of such memory elements. Moreover the present invention provides for increase in the operational speed of high electron mobility heterojunction semiconductor devices.

A high electron mobility heterojunction semiconductor device embodying the present invention is provided with a pair of layers consisting of a first layer of a semiconductor (an electron source layer) containing n type impurities and having a lesser electron affinity and a second layer of a semiconductor (a channel layer) containing no impurities from a practical point of view and having a larger electron affinity, one or more selected portions of the foregoing pair of layers being arranged to allow exposure thereof to irradiation by electromagnetic waves, e.g. light, at a cryogenic temperature, for the purpose of increasing the surface concentration of electrons which are accumulated along the heterojunction between the electron source layer and the channel layer, a cryogenic container being provided for containing the electron source and channel layers therein for the purpose of maintaining the increased surface concentration of electrons accumulated along the heterojunction between the electron source and channel layers, and means being provided for warming the electron source and channel layers (for decreasing the surface concentrations of electrons accumulated along the heterojunction) in a case in which revision or modulation of the characteristics of the device is required to be effected a plurality of times, and preferably means for emitting electromagnetic waves, the means being either contained in or arranged outside the foregoing cryogenic container.

Exposure to electromagnetic waves expedites release of electrons from shallow potential levels contained in the electron source layer and/or from the valence band of the electron source layer. The free electrons released by the exposure increase the surface concentration of the two-dimensional electron gas accumulating along the heterojunction, without any accompanying adverse effects which enhance the problem of ionized impurity scattering.

The increased surface concentration of the two-dimensional electron gas is maintained for a long time, specifically for more than one year, unless the device is warmed far beyond 77°K. Therefore, the device is contained in a cryogenic container.

The preferred temperature range, within which the increased surface concentration of electrons is

5

maintained for a sufficiently long period of time, is generally 150°K or less, although this depends on the potential levels with which the excited free electrons can thermally recombine.

It is preferable to maintain the device within the temperature range of 100°K or less to ensure the maintenance of the increased concentration of electrons.

Incidentally, since the increased surface concentration of the two-dimensional electron gas inevitably decreases with time in accordance with an exponential function, periodical exposure to irradiation, or a type of refreshment, is preferable. This is the reason why means for emitting electromagnetic waves are preferably contained in or arranged outside the cryogenic container.

There are two different types of layer configuration which can be adopted in high electron mobility heterojunction semiconductor devices.

One type is provided with an electron source layer grown on a channel layer, and the other type is provided with a channel layer grown on an electron source layer.

With the former configuration, the electron source layer can be readily exposed to electromagnetic waves.

With the latter configuration, since the thickness of the channel layer is approximately 100 nm (1,000 angstroms), the electron source layer can be exposed to electromagnetic waves which have penetrated the channel layer, despite the fact that the electron source layer is covered by the channel layer.

It will now be understood that the exposure of a high electron mobility heterojunction semiconductor device to electromagnetic waves is effective to increase the surface concentration of the two-dimensional electron gas accumulated in the device, and that warming of a high electron mobility heterojunction semiconductor device is effective to decrease the surface concentration of the two-dimensional electron gas accumulated in the device.

These effects, operating in opposite directions, can be employed in embodiments of the present invention to realise a high electron mobility heterojunction semiconductor device the characteristics of which can be modulated after the completion of the production thereof.

As mentioned above, a high electrom mobility heterojunction semiconductor device can be produced alternatively with a layer configuration having a channel layer grown on an electron source layer.

Incidentally, the effect of increasing the surface concentration of the two-dimensional electron gas without any accompanying increase in ionized impurity scattering readily provides an increased transmission speed for the electrons constituting the two-dimensional electron gas and hence provides an increased operation speed for a high electron mobility heterojunction semiconductor device in accordance with the present invention.

The high electron mobility heterojunction semiconductor device embodying the present invention and described above can be modified. The device may be provided with a buffer layer, of an undoped semiconductor material identical to that of its electron source layer, between its electron source layer and its channel layer.

The electron source layer of the high electron mobility heterojunction semiconductor device embodying the present invention and described above can be provided as an electron source layer containing n type impurities to a relatively low concentration (less than the concentration employed in previous such devices) or as an electron source layer containing no n type impurities from the practical point of view.

An active device, specifically a field effect transistor, belonging to the category of high electron mobility heterojunction semiconductor devices, a HEMT, embodying the present invention is provided with (a) a pair of layers consisting of a first layer of a semiconductor (an electron source layer) containing n type impurities and having a lesser electron affinity and a second layer of a semiconductor (a channel layer) containing no impurities from the practical viewpoint and having a larger electron affinity, the pair of layers being grown on a semi-insulating semiconductor substrate, (b) a control electrode, either of the Schottky barrier type or of the insulated gate type, placed on the foregoing pair of layers, the control electrode allowing electromagnetic waves, e.g. light, to pass therethrough to reach a portion of the electron source layer, which portion is located under the control electrode, for the purpose of enabling the portion of the electron source layer located under the control electrode to be exposed to irradiation by electromagnetic waves, at a cryogenic temperature, to increase the surface concentration of electrons which accumulate along the heterojunction between the electron source and channel layers, (c) a pair of input/output electrodes placed across (to opposite sides of) the foregoing control electrode on the said pair of layers, (d) a cryogenic container containing the said pair of layers provided with the control electrode and the pair of input and output electrodes therein, (e) means for warming the said pair of layers provided with the control electrode and the pair of input and output electrodes (to decrease the surface concentration of electrons accumulated along the heterojunction), in a case in which revision or modulation of the characteristics of the HEMT, e.g. threshold voltage, saturated source current, et al, is required to be effected a plurality of times, and (f) preferably means for emitting electromagnetic waves, those means being contained in or arranged outside the cryogenic container.

There are various alternative forms possible for the control electrode which allows electromagnetic waves to pass through itself. In a case in which the electrode is of the Schottky barrier type, an opening can be provided in a portion of the control electrode or a thin metal film can be employed to allow electromagnetic waves to reach the electron source layer. In a case in which the electrode is of the insulated gate type, a transparent or translucent insulator, such as $Ga_2O_3$ or $Al_2O_3$, can be employed as the material of the insulating layer, on which a metal electrode having an opening provided in a portion thereof, or an electrode of a thin and translucent metal film, is placed.

The functional features of an HEMT in accordance with this embodiment of the present invention will be clear from the foregoing description given above for a high electron mobility heterojunction semiconductor device embodying the present invention.

Such an HEMT embodying the present invention can be modified by the provision of a buffer layer of an undoped semiconductor material, identical to that of the electron source layer, between the electron source and channel layers.

Such an HEMT embodying the present invention can have an electron source layer containing n type impurities to a relatively low concentration (less than the concentration employed in previous HEMT's) or may have an electron source layer containing no n type impurities from the practical point of view.

An HEMT employing the present invention can be provided in a modified form having a configuration wherein (a) the electron source layer is grown on top of the channel layer, (b) a control electrode, which allows electromagnetic waves, e.g. light, to pass therethrough, and a characteristics-modulation electrode are placed on the top surface of a p type well produced in a restricted upper region of the electron source layer containing n type impurities.

With such a modified HEMT the process used for increasing the surface concentration of the two-dimensional electron gas is identical to the process as described above.

The process used for decreasing the surface concentration of the two-dimensional electron gas is to apply to the characteristics-modulation electrode a voltage which is positive relative to that of the input/output electrodes. This voltage causes holes to be supplied to the electron source layer, as a result decreasing the surface concentration of or even destroying the two-dimensional electron gas accumulated along the heterojunction between the electron course and channel layers.

These two effects, which operate in opposite directions, provide for modulation of the characteristics of the HEMT, e.g. modulation of threshold voltage and saturated source current, after the completion of the production thereof.

It must be emphasized that this modified form of HEMT embodying this invention allows modulation of characteristics to any marginal extent or by any incremental amount to meet any specific requirement.

Needless to emphasize, the effect of improvement of operation speed is also available.

The control electrode can be used as the characteristics-modulation electrode. In other words, a characteristics-modulation electrode need not necessarily be provided independently.

A passive device, specifically a connection channel or a capacitor, belonging to the category of high electron mobility heterojunction semiconductor devices, embodying the present invention is provided with (a) a pair of layers consisting of a first layer of a semiconductor (an electron source layer) containing n type impurities and having a lesser electron affinity and a second layer of a semi-conductor (a channel layer) containing no impurities from the practical viewpoint and having a larger electron affinity, the pair of layers being grown on a semi-insulating semiconductor substrate, the surface of the said pair of layers being covered by a film which does not allow electromagnetic waves, e.g. light, to pass therethrough except at one or more portions of the said surface which corresponds or correspond to one or more connection channels and/or electrodes of one or more capacitors, for the purpose of enabling one or more portions of the electron source layer which corresponds or correspond to one or more connection channels or enabling one or more portions of the electron source layer which corresponds or correspond to one or more capacitors, to be exposed to irradiation by the electromagnetic waves, at a cryogenic temperature, and to increase the surface concentration of electrons which accumulate along the heterojunction between the foregoing pair of layers in relation to that one or more portions of the electron source layer, (b) a cryogenic container which contains the said pair of layers partly covered by the opaque film, (c) means for warming the said pair of layers partly covered by the opaque film (to decrease surface concentration of electrons accumulated along the heterojunction) in a case in which revision of modulation of characteristics is required to be effected a plurality of times, and (d) preferably means for emitting electromagnetic waves, the means being contained in or arranged outside the cryogenic container.

Various forms are available in accordance with this embodiment of the present invention in which different materials are used for the opaque film which covers areas of the electron source layer which are not to be exposed to electromagnetic waves. Further forms are available depending on whether or not an area of the electron source layer which is to be exposed to an electromagnetic wave is to be covered with some material.

Such passive devices embodying the present invention, specifically a connection channel and/or a capacitor, can be modified to be provided with a buffer layer of an undoped semiconductor, identical to that of the electron source layer, between the electron source and channel layers.

Such passive devices, specifically a connection channel and/or a capacitor, can be provided with an electron source layer containing a relatively low concentration of n-type impurities (less than in previous such devices) or with an electron source layer containing no n type impurities from the practical viewpoint.

A method of modifying the characteristics of a high electron mobility heterojunction semiconductor device, which can be carried out a plurality of times after completion of production of the device, in accordance with an embodiment of the present invention includes as a first step (a) exposing the high electron mobility heterojunction semiconductor device to electromagnetic waves having a shorter wavelength, preferably to electromagnetic waves having a wavelength corresponding to the band gap of the electron source layer, for the purpose of increasing the surface concentration of electrons accumulated along the heterojunction of the device, and as a second step (b) exposing the high electron mobility heterojunction semiconductor device to electromagnetic waves having a longer wavelength, preferably to electromagnetic waves having a wavelength corresponding to the potential barrier between the electron source layer and the channel layer, for the purpose of decreasing the surface concentration of electrons accumulated along the heterojunction.

In accordance with this embodiment of the present invention, it is possible to downward modulate the surface concentration of the two-dimensional electron gas which has been increased by irradiation with electromagnetic waves. This effect can be employed for erasing memory information stored in a memory element provided with a high electron mobility heterojunction semiconductor device.

A method of modifying characteristics, specifically threshold voltage, saturated source current, et al, of an HEMT provided with an insulated gate produced employing a transparent or translucent insulator, which modification can be carried out a plurality of times after completion of the production of the HEMT, in accordance with an embodiment of the present invention includes as a first step (a) exposing the HEMT to electromagnetic waves whilst the insulated gate type control electrode has applied thereto no voltage or a negative voltage, which will be maintained even after the completion of the exposure, for the purpose of increasing and maintaining the surface concentration of electrons accumulated along the heterojunction of the HEMT, and as a second step (b) applying a positive voltage to the insulated gate type control electrode, or removing the negative voltage which is maintained at the insulated gate type control electrode, for the purpose of decreasing the surface concentration of electrons accumulated along the heterojunction. The application of a positive voltage to the control electrode, after the removal of the negative voltage which is maintained at the control electrode, is of course allowed.

The second step causes expulsion of holes accumulated along the surface between the insulator of the insulated gate type control electrode and the electron source layer into the region close to the heterojunction, as a result decreasing the surface concentration of the two-dimensional electron gas. In accordance with this embodiment of the present invention, two-way modulation of the surface concentration of the electrons accumulated along the heterojunction is possible. This means that in accordance with this embodiment, fine adjustment or precise modulation of characteristics, e.g. threshold voltage, is possible for an HEMT provided with an insulated gate produced employing a transparent or translucent insulator.

A programmable memory device in accordance with an embodiment of the present invention is a matrix produced of a plurality of high electron mobility heterojunction semiconductor devices each of which has a conductive channel consisting of a two-dimensional electron gas and each of which has a pair of input/output electrodes (source and drain electrodes) but has no control electrode (gate) and the characteristics e.g. the resistance of the conductive channel connecting the input and output electrodes of each of which can be modulated after completion of production thereof. All the sources of component high electron mobility heterojunction semiconductor devices (each device is virtually a HEMT from which the gate is removed) contained in a row of the matrix are connected with one another to provide a bit line for the row, and all the drains of the component high electron mobility heterojunction semiconductor devices contained in a column are connected with one another to provide a word line for the column.

The process used to write information into this programmable memory device involves exposing a specific limited portion or specific limited portions of the device, the or each such portion corresponding to the location at which a gate of a component device would be placed, to electromagnetic waves e.g. light, for the purpose of making the component device or devices conductive, leaving all the other component devices non-conductive, thereby to enable discrimination of a device which has been written from other devices which have not been written.

The process used to read information stored in the programmable memory device is similar to processes applicable to memory devices available in the prior art.

The process used to erase the programmable memory device is to warm the memory device beyond 100°K, preferably beyond 150°K. It may, in practice, be impossible in this way to selectively erase the information stored only in selected component memory devices.

It is possible to constitute such programmable memory devices embodying the present invention with HEMTs or high electron mobility heterojunction semiconductor devices each of which has a control electrode or a gate, albeit the control electrodes are unnecessary for writing information.

It is further possible that the gates of the HEMTs constituting such a programmable memory device are of the insulated gate type or that the gates of the HEMTs constituting the foregoing programmable memory device are each produced on a p type well produced in a selected top portion of the n type electron source layer of an HEMT. In either of these cases, it is possible to selectively erase restricted items of information stored in selected ones of the component memory devices of the memory.

A programmable memory device the writing and reading of which are effected by employment of electromagnetic waves, in accordance with an embodiment of this invention, is provided with (a) a pair of layers consisting of a first layer of a semiconductor (an electron source layer) containing n type impurities and having a lesser electron affinity and a second layer of a semiconductor (a channel layer) containing no impurities from the practical viewpoint and having a larger electron affinity, the foregoing pair of layers being divided into a number of areas which are insulated from one another, (b) a cryogenic container which contains the said pair of layers therein, (c) preferably means for warming the said pair of layers, (d) preferably means for emitting first electromagnetic waves employed to irradiate one or some of the divided areas for the purpose of writing information into the specific one or some of the divided areas of the programmable memory device, (e) means for emitting second electromagnetic waves, having a wavelength longer than that of the first electromagnetic waves, these means being scanned over the said pair of layers to read information stored in the programmable memory device, and (f) means sensitive to light, e.g. a set of photodiodes, for receiving light reflected from each of the divided areas.

This embodiment of the present invention is based on a newly discovered and applied principle that reflection factor is weak for an area around which a large quantity of electrons are accumulated and on the principle that electromagnetic waves having a wavelength longer than a specific wavelength are not effective to release the electrons accumulated along a device heterojunction or to destroy a two-dimensional electron gas formed of such electrons.

Equipment for sensing an image in accordance with an embodiment of the present invention is provided with a plurality of HEMTs the characteristics, e.g. threshold voltage, of which can be modulated by irradiation thereof with electromagnetic waves, the plurality of HEMTs being arranged along a line or over a surface as an array or a matrix respectively.

Reference is made, by way of example, to the accompanying drawings, in which:

Figure 1 is a schematic cross-sectional view of a HEMT or an active high electron mobility semiconductor device embodying the present invention, the characteristics of which, specifically the threshold voltage, the saturated source drain current, et al, can be modified after completion of production of the device, the operation speed of which device is increased as compared with previous HEMTs,

Figure 2 is a graph illustrating the tendency of the surface concentration of the two-dimensional electron gas of a HEMT to increase following exposure to amounts of electromagnetic radiation,

Figure 3 is a schematic cross-sectional view of a HEMT or an active high electron mobility semiconductor device embodying the present invention, the characteristics of which can be modulated after completion of production of the device and the operation speed of which is increased, wherein a buffer layer is interleaved between the electron source layer and the channel layer of the HEMT,

Figure 4 is a schematic cross-sectional view of a HEMT or an active high electron mobility semiconductor device embodying the present invention, the characteristics of which can be modulated after completion of production of the device and the operation speed of which is increased, wherein the electron source layer contains no impurities,

Figure 5 is a graph illustrating the relationship between the electron mobility and the surface concentration of a two-dimensional electron gas,

Figure 6 is a schematic cross-sectional view of a HEMT or an active high electron mobility semiconductor device embodying the present invention, which allows fine modulation or fine adjustment of the characteristics thereof, without warming, wherein the electron source layer is provided with a p-n junction in an upper portion thereof, and a control electrode and a characteristics-modulation electrode are placed on the top surface of the p type region of the electron source layer,

Figure 7 is a schematic cross-sectional view of a HEMT embodying the present invention provided with connection channels or passive devices,

Figure 8 is an energy band diagram of a high electron mobility heterojunction semiconductor device provided with an electron source layer of AlGaAs containing n type impurities and a channel layer of of GaAs containing no impurities,

Figure 9 is a schematic cross-sectional view of a HEMT provided with an insulated gate produced on a transparent or translucent insulator in accordance with an embodiment of the present invention,

Figure 10 is an energy band diagram of a HEMT provided with an insulated gate, illustrating the condition of the HEMT after exposure to light at a cryogenic temperature,

Figure 11 is an energy band diagram of a HEMT provided with an insulated gate, illustrating the condition of the HEMT after a control gate of the HEMT has had a positive voltage applied thereto,

Figure 12 is a schematic cross-sectional view of a programmable memory device, embodying the present invention, provided with a plurality of high electron mobility heterojunction semiconductor devices having no electrodes, or a plurality of insulated blocks of layer configuration provided with an electron source layer of a semiconductor having a lesser electron affinity and containing n type impurities and a channel layer of a semiconductor having a larger electron affinity and containing no impurities,

Figure 13 is a schematic plan view of a programmable memory device of which the cross-sectional view is illustrated in Figure 12,

Figure 14 is a schematic cross-sectional view of a component element of a device embodying the present invention for sensing an image,

Figure 15 is a schematic diagram illustrating connections in an array type image sensor embodying the present invention,

Figure 16 is a schematic diagram illustrating connections in a matrix type image sensor embodying the present invention, and

Figure 17 is a schematic side view of a device for sensing an image, embodying the present invention.

In the following description, one example of each of the main kinds of embodiment of the present invention will be described, on the assumption that the materials of the electron source layer and the channel layer are AlGaAs and GaAs respectively.

HEMTs or active high electron mobility heterojunction semiconductor devices in accordance with embodiments of the present invention will now be described below.

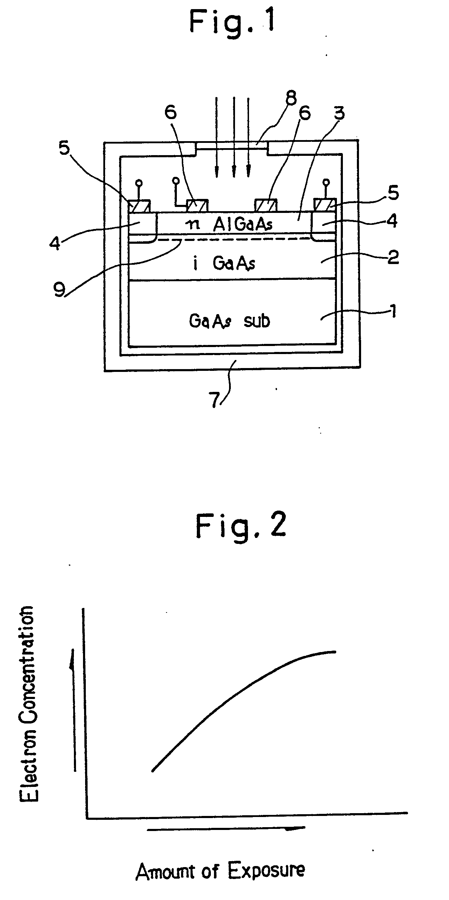

Referring to Figure 1, a molecular beam epitaxial process is employed to grow an AlGaAs layer 3 (an electron source layer) containing n type impurities to a relatively low concentration (e.g. a lesser concentration than employed in previously proposed high electron mobility heterojunction semiconductor devices) on an undoped GaAs layer 2 (a channel layer) containing no impurities from the practical point of view (it will be understood that the channel layer contains no intentional impurities, but it may contain incidental or unavoidable impurities), grown on a Cr doped semi-insulating GaAs substrate 1. The layer configuration is selected so as not to allow a two-dimensional electron gas 9 to accumulate along the heterojunction between the electron source layer 3 and the channel layer 2. In other words, the layer configuration is selected to satisfy the requirements for production of a normally-off type or enhancement mode HEMT. A pair of input/output electrodes 5 each having a double layer structure of Au-Ge and Au are ohmicly connected with the channel layer 2 through a pair of alloyed regions 4. A control electrode 6 of Al is placed between the input and output electrodes 5 on the top surface of the electron source layer 3. The control electrode 6 has a circular shape for the purpose of allowing electromagnetic waves to reach the electron source layer 3. It is alternatively possible to produce the control electrode 6 of a thin film of an electro-conductive material such as to satisfy two requirements:— electro-conductivity and transparency. Once a portion of the electron source layer 3 located below the control electrode 6 is exposed to electromagnetic waves, e.g. light, at a cryogenic temperature, electrons 9 accumulate along the heterojunction between the electron source layer 3 and the channel layer 2 due to the difference between the electron affinities of those layers, as a result enabling the modulation or revision of the surface concentration of the electrons 9 which may exist to provide a conductive channel which connects the input and output electrodes, and as a further result enabling modulation or revision of the characteristics of the active high electron mobility heterojunction conductor device or the HEMT to be carried out after the completion of the production thereof. Since this two-dimensional electron gas 9 is maintained, once created, unless the device is warmed far beyond 77°K, the device is to be kept at a cryogenic temperature. This is the reason why the device is contained in a cryogenic container 7. Since it is possible to reduce the surface concentration of or to entirely destory the two-dimensional electron gas 9 by warming the device up to 150°K or more, a means to warm the device or the pair of layers 2 and 3 is provided in a case in which revision or modulation of characteristics thereof, for example threshold voltage and saturated source current, may be required to be effected a plurality of times.

Since the modulation or revision of the characteristics of the device is implemented by exposure of the layer configuration to electromagnetic waves, some source of electromagnetic waves, e.g. light, is needed. This source of electromagnetic waves can either be arranged outside the cryogenic container 7, which in this case is provided with a window 8 which allows penetration therethrough of electromagnetic waves, or contained in the cryogenic container 7.

Albeit that the two-dimensional electron gas 9, once created, is maintained for a period long enough from a practical point of view, its concentration inevitably decreases with time in accordance with an exponential function. Therefore, it is preferable that means provided for emitting electromagnetic waves be accompanied by a regulator which allows periodical operation of those means. In this case, a group of semiconductor photodiodes accompanied by a mask having a specific pattern in accordance with a specific requirement may be preferable for use as the means for emitting electromagnetic waves just from a practical viewpoint.

Experimental results show that the surface concentration of the two-dimensional electron gas 9 can be successfully increased in accordance with the amount of light having a wavelength shorter than 10 micrometers to which the device of Figure 1 is exposed, as illustrated in the graph of Figure 2.

The foregoing description makes it clear that a HEMT or an active high electron mobility heterojunction semiconductor device embodying the present invention provides for modulation or revision of the characteristics, e.g. the threshold voltage, saturated source drain current, et al, of the HEMT or the active semiconductor device to be carried out after completion of production thereof.

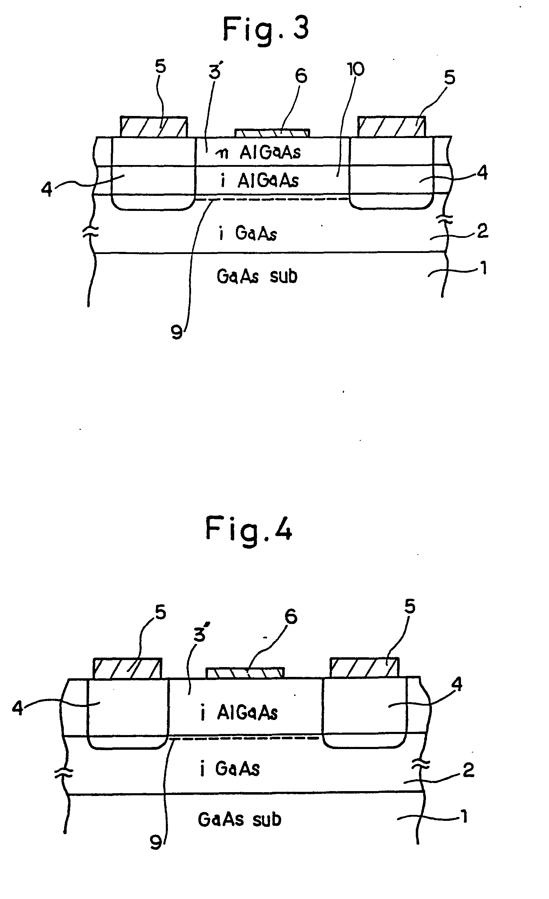

Referring to Figure 3, a molecular beam epitaxial process is employed to grow an AlGaAs layer 3' (an electron source layer) containing n type impurities to a relatively small concentration (e.g. a lesser concentration than employed in previously proposed high electron mobility heterojunction semiconductor devices) and having a thickness of 35 nm (350 angstroms) on an undoped AlGaAs layer 10 (a buffer layer) containing no n type impurities from the practical point of view and having a thickness of 15 nm (150 angstroms) grown on an undoped GaAs layer 2 (a channel layer) containing no impurities from the practical point of view grown on a Cr doped semi-insulating GaAs substrate 1. A pair of input/output electrodes 5 each made of a double layer structure of Au-Ge and Au are ohmicly connected with the channel layer 2 through a pair of alloyed regions 4. A control electrode 6 of an Al thin film having a thickness of 100 angstroms is placed between the input and output electrodes 5 on the top surface of the electron source layer 3'. Since the thickness of the control electrode 6 is very small, it allows electromagnetic waves to penetrate it. The situation is the same as for the embodiment of Figure 1 with regard to the use of a cryogenic container, the preference for the provision of means to warm the device, and the preference for the provision of means for emission of electromagnetic waves for example accompanied by a regulator which allows periodical operation of those means. In the layer configuration of Figure 3, a two-dimensional electron gas 9 accumulates along the heterojunction between the buffer layer 10 and the channel layer 2. However, the surface concentration of the two-dimensional electron gas 9 and the electron mobility thereof are respectively $3.5 \times 10^{11}/cm^2$ and 160,000 $cm^2/Vsec$ at 77°K and are respectively $3.4 \times 10^{11}/cm^2$ and 540,000 $cm^2/Vsec$ at 5°K. Once a portion of the electron source layer 3' is exposed to electromagnetic waves, at a cryogenic temperature, the surface concentration of the two-dimensional electron gas 9 and the electron mobility thereof respectively increase to $5.0 \times 10^{11}/cm^2$ and 180,000 $cm^2/Vsec$ at 77°K and to $5.7 \times 10^{11}/cm^2$ and 1,050,000 $cm^2/Vsec$ at 5°K.

The foregoing description makes it clear that a HEMT or an active high electron mobility heterojunction semiconductor device in accordance with this embodiment of the present invention, wherein a buffer layer of an AlGaAs layer containing no n type impurities is additionally provided, provides not only for the possibility of modulation or revision of the characteristics, e.g. threshold voltage, saturated source drain current et al, but also for an increase in the electron mobility of the two-dimensional electron gas, resulting in an increased operation speed of the HEMT or the active semiconductor device.

Figure 4 illustrates the layer configuration of a HEMT or an active high electron mobility heterojunction semiconductor device which allows modulation of characteristics thereof, e.g. threshold voltage, saturated source current et al, to be carried out after the completion of the production thereof in accordance with another embodiment of the present invention. The major differences between the layer configuration of this embodiment and the layer configuration of the embodiment illustrated in Figure 1 are that an electron source layer 3'', in the embodiment of Figure 4 having a thickness of 50 nm (500 angstroms) does not contain any n type impurities from the practical viewpoint and that the control electrode 6 is a thin Al film which allows penetration therethrough of electromagnetic waves. The situation is the same as for the foregoing embodiments with regard to the use of a cryogenic container, the preference for the provision of means to warm the device, and the preference for the provision of means for emission of electromagnetic waves for example accompanied by a regulator which allows periodical operation of those means.

In the layer configuration of Figure 4, no two-dimensional electron gas 9 accumulates along the heterojunction between the electron source layer 3'' and the channel layer 2 prior to exposure to electromagnetic waves. However, once a portion of the electron source layer 3'' is exposed to electromagnetic waves at a cryogenic temperature, electrons are released from shallow potential levels contained in the electron source layer and/or from the valence band of the electron source layer, and electrons 9 accumulate along the heterojunction between the the electron source layer 3'' and the channel layer 2 due to the difference in the electron affinities of those layers. This means that modulation or revision of the characteristics of the device can be carried out by exposure of the device to electromagnetic waves. Moreover, experimental results show that the surface concentration of the two-dimensional electron gas 9 and the electron mobility thereof are respectively $4.5 \times 10^{11}/cm^2$ and 200,000 $cm^2/Vsec$ at 77°K and are respectively $5.0 \times 10^{11}/cm^2$ and 1,200,000 $cm^2/Vsec$ at 5°K. In comparison with experimental results for the pre-exposure condition of the layer configuration illustrated in Figure 1, this indicates that a considerable improvement can be obtained, particularly in relation to the electron mobility available at 5°K, as a result offering a considerable improvement in the operation speed of the HEMT or the active high electron mobility heterojunction semiconductor devices.

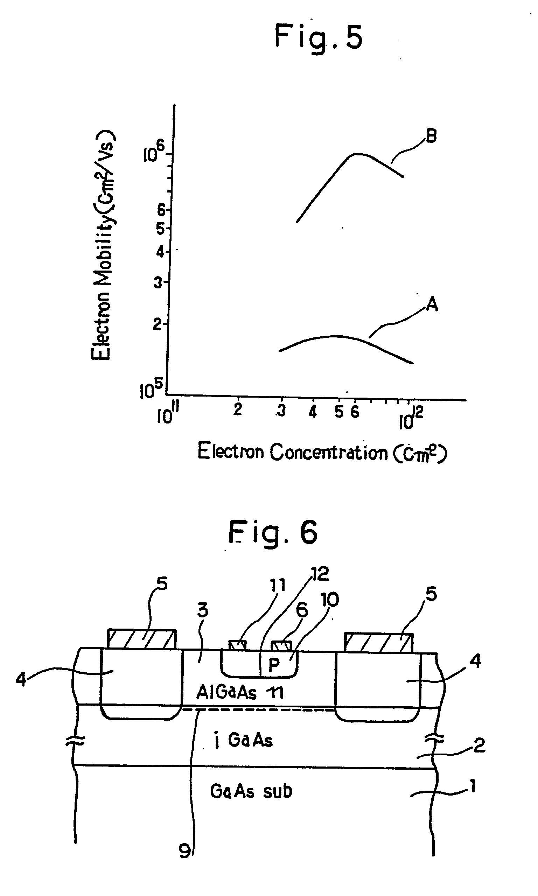

It is interesting that the relationship between the electron mobility and the surface concentration of the two-dimensional electron gas is not linear but has a peak, as illustrated in the graph of Figure 5, albeit that the surface concentration of the two-dimensional electron gas increases in accordance with the amount of electromagnetic waves to which a device is exposed, as illustrated in Figure 2. In Figure 5, the curve A and curve B respectively show experimental results at 77°K and 5°K. These phemonena, in combination with the exponential decrease in the surface concentration of the two-dimensional electron gas after exposure, can be parameters for selection of preferable amounts of exposure.

The foregoing description makes it clear that a HEMT or an active high electron mobility heterojunction semiconductor device in accordance with an embodiment of the present invention in which the electron source layer contains no n type impurities provides for the possibility of modulation or revision of the characteristics, e.g. threshold voltage, saturated source drain current et al, of the device after completion of production thereof, and a further increase in the electron mobility of the two-dimensional electron gas, resulting in a further increased operation speed of the HEMT or the active semiconductor device.

Figure 6 illustrates the layer configuration of a HEMT or an active high electron mobility heterojunction semiconductor device which allows modulation of characteristics, e.g. threshold voltage, saturated source drain current et al, to be carried out after completion of production thereof, in accordance with another embodiment of the present invention. The major differences between the layer configuration of the embodiment of Figure 6 and the layer configuration illustrated in Figure 1, are that a p type well 10 is produced in a restricted upper region of the electron source layer 3, containing n type impurities, for the purpose of producing a p-n junction 12 therebetween, that a control electrode 6, of an Au-Zn film which is thin enough to allow electromagnetic waves, e.g. light, to pass therethrough and having a circular shape, and a characteristics-modulation electrode 11 are placed on the top surface of the foregoing p type well 10.

The control electrode 6 can be used also as the characteristics-modulation electrode 11. In other words, the characteristics-modulation electrode 11 is not necessarily an independent item.

Since the thickness of an electron source layer 3 is orginarily less than 0.1 micrometers, it is not necessarily easy to produce a p-n junction in a layer having such a small thickness. Therefore, it is easy and convenient to produce a p type region in the top portion of an undoped AlGaAs layer grown on an electron source layer constituted by an n type AlGaAs layer. In this case, a p-i-n junction is produced rather than a p-n junction.

Another method is available in which a p type AlGaAs layer is grown on an electron source layer constituted by an n type AlGaAs layer, before the p type AlGaAs layer is removed by an etching process, leaving the p type AlGaAs layer selectively on a control electrode and on a characteristics-modulation electrode. In this case, one or more mesas remain on the top surface of the layer configuration.

The situation is the same as for the foregoing embodiments, with regard to the use of a cryogenic container, the preference for the provision of means for emission of electromagnetic waves for example accompanied by a regulator which allows periodical operation of those means. However, means for warming the device is not necessary, because decrease of the surface concentration of, or destruction of, the two-dimensional electron gas can be carried out as described below without warming the device.

The process used for increasing the surface concentration of the two-dimensional electron gas is quite identical to the processes to be used in connection with HEMTs in accordance with any of the foregoing embodiments of this invention. In other words, the electron source layer is exposed to electromagnetic waves, e.g. light, having a wavelength short enough to excite electrons contained in shallow levels or even the valence band of the material of the electron source layer, while the device is maintained at a cryogenic temperature or a temperature less than $150°K$.

The process used for decreasing the surface concentration of the two-dimensional electron gas is to apply a positive voltage to the characteristics-modulation electrode 11 and a negative voltage to the input/output electrodes 5. This causes holes to move from the p type well 10 to the n type region of the electron source layer 3. As a result, the surface concentration of the two-dimensional electron gas 9 is decreased in accordance with the voltage applied between the characteristics-modulation electrode 11 and the input/output electrodes 5. If this voltage is sufficiently large, the two-dimensional electron gas is entirely destroyed.

It must be emphasised that HEMTs in accordance with this embodiment of the present invention allow modulation of the characteristics, e.g. threshold voltage, saturated source drain current et al, to any required marginal extent in accordance with the voltage applied. Therefore, a fine adjustment or modulation of threshold voltage, saturated source drain current, et al, is readily possible without warming the device.

The foregoing description makes it clear that a HEMT or an active high electron mobility heterojunction semiconductor device in accordance with this embodiment of the present invention in which the electron source layer is provided with a p-n junction and in which a control electrode and a characteristics-modulation electrode are placed on the top surface of a p type region, provides for the possibility of a fine modulation or a fine adjustment of characteristics, e.g. threshold voltage, saturated source drain current, et al, without warming the device.

Passive high electron mobility heterojunction semiconductor devices in accordance with embodiments of the present invention will now be described. Specifically (1) a connection channel which connects a source and a gate or a gate and a drain of a transistor, (2) a connection channel which connects transistors produced in one chip, or (3) an electrode of a capacitor, in accordance with an embodiment of the present invention will be described below.

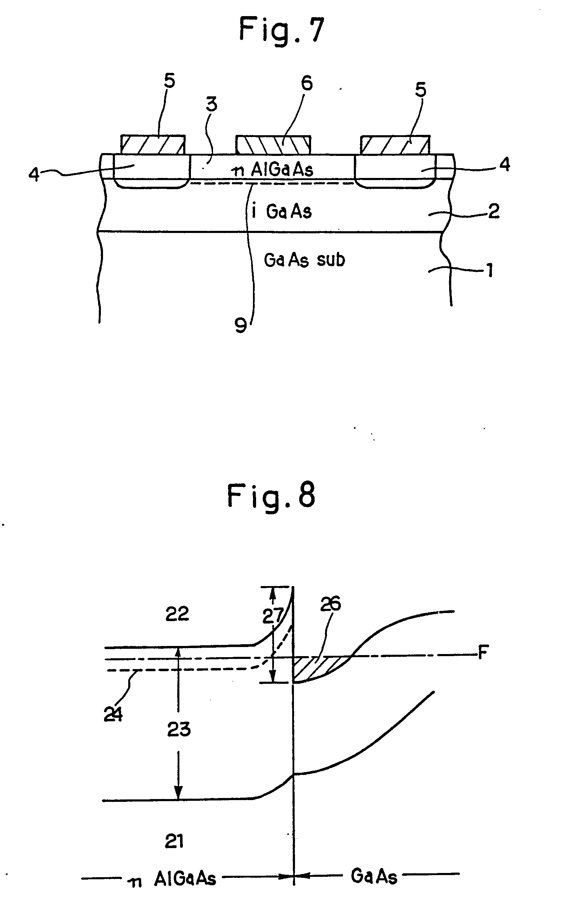

Figure 7 illustrates a layer configuration of a HEMT provided with connection channels, in accordance with an embodiment of the present invention, which connect the source and the gate and the gate and the drain of the HEMT.

Referring to Figure 7, a molecular beam epitaxial process is employed to grow an AlGaAs layer 3 (an electron source layer) containing n type impurities to a relatively low concentration on an undoped GaAs layer 2 (a channel layer) containing no impurities from the practical viewpoint grown on a Cr doped semi-insulating GaAs substrate 1. The n type impurity concentration of the electron source layer 3 is selected to be $2\times10^{18}/cm^3$. The thicknesses of the electron source layer 3 and the channel layer 2 are selected respectively to be 0.06 micrometers and 0.6 micrometers. This lattice profile allows a two-dimensional electron gas 9 to accumulate with the surface concentration of $3\times10^{11}/cm^2$. A pair of input/output electrodes 5 each made of a double layer structure of Au-Ge and Au are ohmicly connected with the channel layer 2 through a pair of alloyed regions 4 which are produced employing an annealing process at 450°C. A control electrode 6 of Al is placed between the input and output electrodes 5 on the top surface of the electron source layer 3.

Once the electron source layer 3 is exposed to electromagnetic waves, e.g. light having a wavelength shorter than that corresponding to the band gap of AlGaAs at a cryogenic temperature around 77°K, the surface concentration and the electron mobility of the two-dimensional electron gas are increased, resultantly decreasing the resistance of the connection channels which connect the source and the gate and the gate and drain of the HEMT. As a result, the cut-off frequency of the HEMT increases and the noise level of the HEMT decreases. During the exposure process, the control gate acts as a mask. Therefore, the original characteristics of the HEMT, e.g. threshold voltage, saturated source drain current et al, of the HEMT, are not influenced by the exposure.

In cases in which a passive device in accordance with this embodiment is employed as a connection channel which connects transistors or is employed as an electrode of a capacitor, an opaque film which covers the area or areas of the electron source layer which are not to be exposed to electromagnetic waves is required.

Experimental results in relation to Figure 7 have shown that the surface concentration and the electron mobility of two-dimensional electron gas can be increased to respectively $9.0 \times 10^{11}$ cm$^2$ and 152,000 cm$^2$/Vsec from respectively $4.7 \times 10^{11}$/cm$^2$ and 103,000$^2$/Vsec, resultantly causing the resistance between the source and the drain to be reduced to 1/3 its original value.

The situation is the same as for the foregoing embodiments as regards the use of a cryogenic container, the preference for the provision of means to warm the device, and the preference for the provision of means for emission of electromagnetic waves for example accompanied by a regulator which allows periodical operation of those means.

The foregoing description makes it clear that a passive high electron mobility heterojunction semiconductor device in accordance with an embodiment of the present invention can provide for a reduction in resistance of (1) connection channels or (2) an electrode of a capacitor, offering improvement with regard to the cut-off frequency and the noise level of HEMTs, in cases in which such connection channels are employed for HEMTs, or with regard to the time constant of capacitors, in cases in which such electrodes are employed for capacitors.

It is possible to use a buffer layer and/or an electron source layer of a semiconductor containing no impurities in embodiments of the present invention relating to passive devices.

A method of modulating the characteristics of a high electron mobility heterojunction semiconductor device a plurality of times after completion of production of the device, in accordance with an embodiment of the present invention, will now be described.

Figure 8 is an energy band diagram of a high electron mobility heterojunction semiconductor device provided with an AlGaAs layer containing n type impurities (an electron source layer) and a GaAs layer containing no impurities (a channel layer).

Referring to Figure 8, 21 and 22 indicate respectively the valence band and the conduction band. F is the Fermi level. The band gap of AlGaAs, indicated at 23, is approximately 1.8 eV. The difference in electron affinities of AlGaAs and GaAs allows electrons of a shallow level 24, caused by introduction of Si as a donor, to accumulate in a potential well 26. Once the electron source layer of AlGaAs containing n type impurities is exposed to light having a wavelength shorter than the wavelength corresponding to the band gap 23, or 1.8 eV, at a cryogenic temperature, an additional quantity of electrons moves from the valence band 21 to the potential well 26. This two-dimensional electron gas which accumulates along the heterojunction between the electron source layer and the channel layer remains unreleased even after exposure to light emission is terminated, because a potential barrier 27 between the electron source layer and the channel layer, amounting to 0.3 eV, prevents the two-dimensional electron gas from moving backward to the valence band 21 of the electron source layer. This is the principle which allows the exposure of a high electron mobility heterojunction semiconductor device to electromagnetic waves, e.g. light, to increase the surface concentration of and the electron mobility of the two-dimensional electron gas. The two-dimensional electron gas can be released by application of an amount of energy in excess of the potential barrier 27 between the electron source layer and the channel layer. Therefore, irradiation with light having a wavelength corresponding to the potential barrier is effective to release the two-dimensional electron gas. On the other hand, however, this amount of energy is not large enough to move electrons from the valence band 21 of the electron source layer to the potential well 26. Therefore, the foregoing application of a light or an electromagnetic wave is effective to modulate or revise the surface concentration of the two-dimensional electron gas.

Thus, a method which includes as a first step (a) exposing a high electron mobility heterojunction semiconductor device to electromagnetic waves having a shorter wavelength, preferably electromagnetic waves (e.g. light) having a wavelength corresponding to the band gap of the electron source layer thereof, for the purpose of increasing the surface concentration of the two-dimensional electron gas, and as a second step (b) exposing the high electron mobility heterojunction semiconductor device to electromagnetic waves having a wavelength corresponding to the potential barrier between the electron source layer and the channel layer, for the purpose of decreasing the surface concentration of the two-dimensional electron gas, provides for the modulation of device characteristics a plurality of times after completion of production of the device.

In the case of the embodiment of the present invention the layer configuration of which is illustrated in Figure 8, the long wavelength end of a preferable wavelength range for light employed for the first step is approximately 0.7 micrometers, because the band gap of AlGaAs is 1.8 eV. The long wavelength end of the preferable wavelength range for light employed for the second step is approximately 4 micrometers, because the potential barrier between AlGaAs and GaAs is 0.3 eV.

The foregoing description makes it clear that a method in accordance with an embodiment of the present invention provides for the possibility of upward and downward modulation of the surface concentration of the two-dimensional electron gas. This method is effective in allowing a diversification of the uses of high electron mobility heterojunction semiconductor devices, in particular to the field of memory devices, because this method can be utilised for writing and erasure of data stored in a memory element on the basis of the principle that the characteristics of a high electron mobility heterojunction semiconductor device, e.g. a HEMT, can be modulated by exposure thereof to electromagnetic waves, e.g. light.

A method embodying the present invention will now be described for modulation of characteristics, specifically the threshold voltage, of a HEMT provided with an insulated gate produced employing a transparent or translucent insulator, a plurality of times after the completion of production of the device.

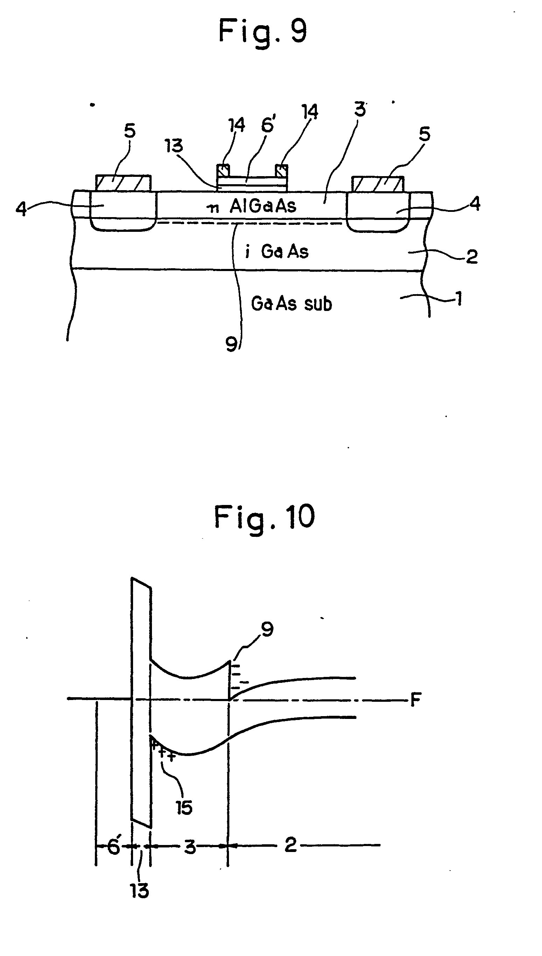

Figure 9 illustrates the layer configuration of a HEMT provided with an insulated gate produced on a transparent or translucent insulator such as $Ga_2O_3$, $Al_2O_3$ or the like. Referring to Figure 9, an AlGaAs layer 3 (an electron source layer) having a thickness of 0.1 micrometers and containing n type impurities to a concentration of $1\times10^{18}/cm^3$ is grown on a GaAs layer 2 (a channel layer) having a thickness of 1 micrometer and containing no impurities from the practical viewpoint grown on a Cr doped semi-insulating GaAs substrate 1. This lattice profile allows a two-dimensional electron gas 9 having an electron mobility of $1.1\times10^5 cm^2/Vsec$ to accumulate with a surface concentration of $5\times10^{11}/cm^2$. A pair of input/output electrodes 5 made each of a double layer structure of Au-Ge and Au having a thickness of 0.3 micrometers are ohmicly connected with the channel layer 2 through a pair of alloyed regions 4 produced employing the annealing process at 450°C. 13 is an insulator layer of a mixture of $Al_2O_3$ and $Ga_2O_3$ produced employing an oxidation process applied at a temperature of 550°C to the AlGaAs layer 3 partly covered by an $SiO_2$ mask. On top of this insulator layer 13 having a thickness of 0.04 micrometers, a control electrode 6' is plated. The electrode 6' is of an Al film which is thin enough to pass light therethrough, for example 10 nm (100 angstroms) thick. To obtain a good ohmic connection with this control electrode 6', a circular bonding pad 14 of an Au film having a thickness of 0.3 micrometers is arranged on the control electrode 6'.

The situation is the same as for the foregoing embodiments, as regards the use of a cryogenic container, the preference for the provision of means to warm the device, and the preference for the provision of means for emission of electromagnetic waves for example accompanied by a regulator which allows periodical operation of those means.

Once the control electrode 6' is exposed to electromagnetic waves, e.g. light, at a cryogenic temperature, e.g. 77°K, the surface concentration of and the electron mobility of the two-dimensional electron gas 9 are respectively increased to $9\times10^{11}/cm^2$ and $1.4\times10^5$ $cm^2/Vsec$ at the cryogenic temperature, resultantly increasing the threshold voltage to 0.7 V from 0.5 V at 77°K.

Figure 10 is an energy band diagram of the foregoing HEMT, showing its condition after exposure to a light at a cryogenic temperature.

Referring to Figure 10, the two-dimensional electron gas 9 accumulates along a heterojunction between the channel layer 2 and the electron source layer 3, and holes 15 accumulate in the electron source layer 3 along with the interface with the insulating layer 13.

The foregoing exposure of the control electrode 6' to electromagnetic waves is much more effective if it is carried out whilst the control electrode 6' has a negative voltage of approximately 0.3V applied thereto.

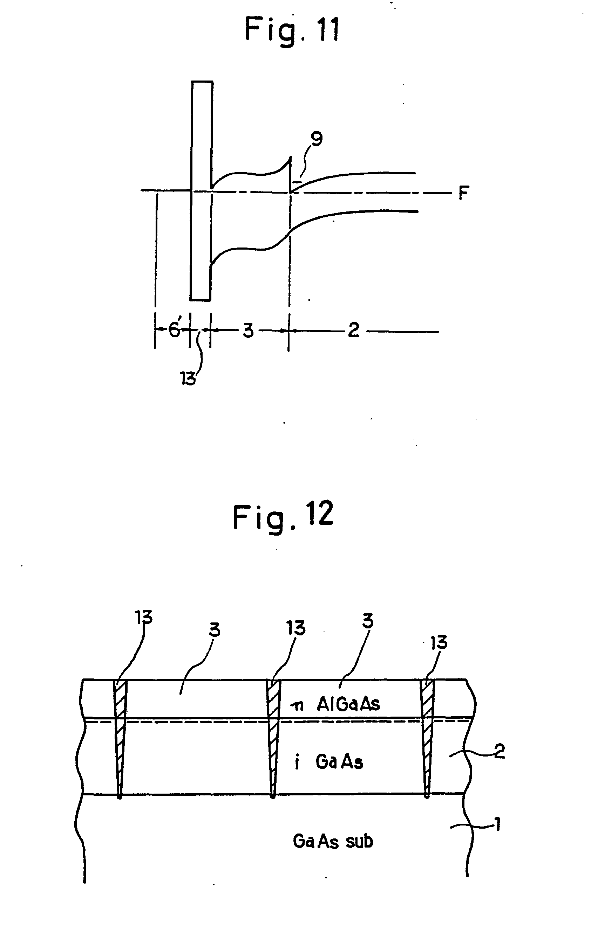

Thereafter, when a positive voltage of e.g. 1.2V is applied to the control gate 6', the condition of the device changes to that illustrated by the energy band diagram illustrated in Figure 11.

By reference to Figure 11, it will be seen that the holes 15 accumulated along the interface between the insulating layer 13 and the electron source layer 3 are expelled towards the channel layer 2, resultantly decreasing the surface concentration of the two-dimensional electron gas 9.

The surface concentration of the two-dimensional electron gas 9 accumulated by the exposure of the control electrode 13 to electromagnetic waves under the condition that the control electrode 13 is applied with a negative potential, can be reduced to any desired extent in accordance with the positive voltage applied thereto. This means that a fine downward modulation of the surface concentration of the two-dimensional electron gas is possible.

Thus, a method which includes as a first step exposing a HEMT provided with an insulated gate, produced employing a transparent or translucent insulator, to electromagnetic waves whilst the insulated gate type control electrode is supplied with no voltage or a negative voltage, for the purpose of increasing the surface concentration of the two-dimensional electron gas, and as a second step supplying a positive voltage to, or removing the negative voltage from, the insulated gate type control electrode, for the purpose of decreasing the surface concentration of the two-dimensional electron gas, provides for modulation of the characteristics of the device a plurality of times after completion of production thereof.

The foregoing description makes it clear that a method in accordance with this embodiment of the present invention provides for the fine adjustment or precise modulation of the characteristics, particularly the threshold voltage, of a HEMT provided with an insulated gate produced employing a transparent or translucent insulator such as $Ga_2O_3$, $Al_2O_3$ or the like.

A programmable memory device in accordance with an embodiment of the present invention will now be described below.

High electron mobility heterojunction semiconductor devices, including HEMTs, in accordance with the present invention allow modulation of the characteristics thereof, for example the resistance of a conductive channel thereof, such modulation being carried out by exposure of the devices to electromagnetic waves, e.g. light, at a cryogenic temperature.

This means that selective exposure of a selected one of a group of high electron mobility heterojunction semiconductor devices, such as HEMTs, to light for example from a laser enables discrimination of the exposed device from amongst the others of the group of high electron mobility single heterojunction semiconductor devices.

This further means that it is possible to constitute a memory device of a plurality of high electron mobility heterojunction semiconductor devices. Writing of the memory device may be carried out by selective exposure of an addressed one of the high electron mobility heterojunction semiconductor devices of the memory device and reading can be carried out by selection of a high electron mobility heterojunction semiconductor device of which the resistance is different from the others.

Thus, a matrix including a plurality of high electron mobility heterojunction semiconductor devices each of which has an input electrode and an output electrode and a conductive channel constituted by a two-dimensional electron gas which accumulates upon exposure of the device to electromagnetic waves (or each of which is a HEMT from which the control electrode is removed), and each of which allows modulation of the characteristics thereof by exposure of the device to electromagnetic waves provides a programmable memory device.

In such a programmable memory device, all the input electrodes of the high electron mobility heterojunction semiconductor devices in one row are connected with one another to provide the bit line of the row, and all the output electrodes of the high electron mobility heterojunction semiconductor devices contained in one column are connected with one another to provide the word line of the column.

The process used for writing information into this programmable memory device is to selectively expose an addressed one of the group of devices making up the memory to electromagnetic waves. The process used for reading information stored in the programmable memory device is to apply a voltage to each of the individual devices in progression, and is usual with the process for the memory devices available in the prior art. The process used for erasing information stored in the programmable memory device is simply to warm the programmable memory device beyond at least 100°K.

Various alternative forms and/or modifications of the foregoing programmable memory device are available in accordance with embodiments of the present invention.

For example (a) a programmable memory device provided with a plurality of HEMTs which permit modulation of the characteristics thereof by exposure thereof to electromagnetic waves in accordance with an embodiment of the present invention, (b) a programmable memory device provided with a plurality of HEMTs each of which is provided with an insulated gate type control electrode in accordance with an embodiment of the present invention as described above, and (c) a programmable memory device provided with a plurality of HEMTs each of which is provided with a control electrode and a characteristics-modulation electrode provided on a p type well produced in a restricted upper region of the electron source layer in accordance with an embodiment of the present invention as described above.

The foregoing description makes it clear that a plurality of programmable memory devices can be provided in accordance with the present invention which comprise a plurality of high electron mobility heterojunction semiconductor devices the characteristics of which can be modulated by exposure thereto to electromagnetic waves.

A programmable memory device embodying the present invention the writing and reading of which are effected by employment of electromagnetic waves will be described below.

The present inventors have discovered a new phenomenon relating to high electron mobility heterojunction semiconductor devices and have devised the means by which that new phenomenon can be employed.

The modulation of characteristics of a high electron mobility heterojunction semiconductor device effected by exposure thereof to electromagnetic waves at a cryogenic temperature in accordance with the present invention can provide a unique medium for a memory function.

The inventors have determined that the reflection factor of a region in which the surface concentration of the two-dimensional electron gas is increased by exposure of the region to electromagnetic waves is different from the reflection factor of a region in which the surface concentration of the two-dimensional electron gas has not yet been increased by exposure of the region to electromagnetic waves.

The inventors have further determined that after selective exposure of a selected one of a group of high electron mobility heterojunction semiconductor devices of a specific type, none of which devices is provided with any electrode, the selected exposed one can be discriminated from the others of the group.

A high electron mobility heterojunction semiconductor device of this specific type can be employed as a memory element which can also be considered as an insulated block having a layer configuration provided with an electron source layer of a semiconductor having a lesser electron affinity and containing n type impurities and a channel layer of a semiconductor having a larger electron affinity and containing no impurities. Since such a memory element is not provided with any type of electrode, it may not be appropriate to consider the memory element as falling into the category of electronic devices. In any case, however, a matrix including a plurality of such memory elements can evidently act as a programmable memory device, when it is additionally provided with a means to emit first electromagnetic waves, employed to write information into memory elements, means to emit second electromagnetic waves, having a wave-length longer than that of the first electromagnetic waves, which are scanned over the matrix to read the information stored in the memory elements, and means sensitive to light e.g. a set of photosensitive elements which received light reflected from each of the memory elements.

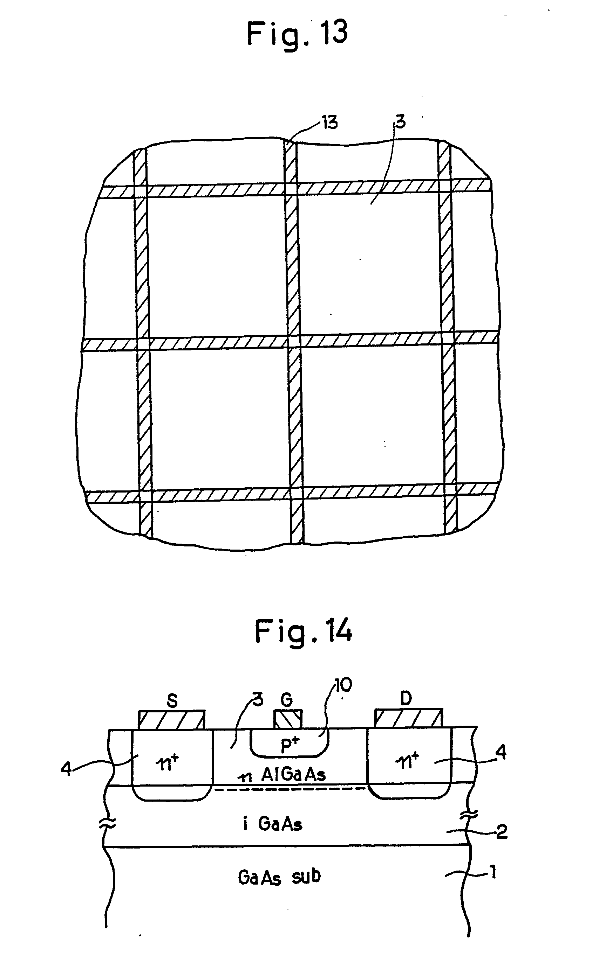

Figures 12 and 13 illustrate a programmable memory device in accordance with the present invention. An electron source layer 3 of AlGaAs containing n type impurities is grown on a channel layer 2 of GaAs containing no impurities grown on a Cr doped semi-insulating GaAs substrate 1. Double layer structures each consisting of an electron source layer 3 and a channel layer 2 are divided from one another, to provide a plurality of memory elements insulated from one another, by a plurality of insulating belts 13.

The writing process used for the device of Figures 12 and 13 involves exposing an addressed memory element to electromagnetic waves, e.g. light for example from a laser, having a wavelength short enough to cause a two-dimensional electron gas 9 to accumulate along the heterojunction between the electron source layer 3 and the channel layer 2 of the element. Since each memory element is insulated from the others, the two-dimensional electron gas is maintained in the addressed memory element. The reading process used involves exposing each memory element in progression, e.g. by means of scanning of radiation, to electromagnetic waves, e.g. light for example from a laser, having a wavelength long enough not to disperse the two-dimensional electron gas, so that a photosensitive element can determine whether or not a two-dimensional electron gas is accumulated in an addressed memory element by detecting the amount of radiation reflection therefrom. The memory can be erased by warming the memory device.

Various alternative forms and/or modifications embodying the present invention are available for the foregoing programmable memory device, in accordance with methods of erasure of stored information. For example (a) a programmable memory device provided with a plurality of insulated blocks of layer configuration as described above each of which is further provided with an insulated gate type control electrode and each of which is insulated from the others, and (b) a programmable memory device provided with a plurality of insulated blocks each of layer configuration which has an electron source layer grown on the channel layer and each of which has a control electrode placed on a p type well produced in a restricted upper region of the electron source layer.

The foregoing description makes it clear that a plurality of programmable memory devices in respect of which writing and reading of information are effected by employment of electromagnetic waves e.g. light or laser, can be provided in accordance with the present invention.

Equipment for sensing an image, having a memory function and/or having a large cross-sectional area, embodying the present invention will be described below.

Referring to Figure 14, each constituent element of image sensing equipment in accordance with this embodiment of the present invention is an active high electron mobility heterojunction semiconductor device or a HEMT provided with a layer configuration consisting of an electron source layer 3 of AlGaAs containing n type impurities and a channel layer 2 of GaAs containing no impurities, a gate electrode G being placed on a p type region 10 produced in a limited upper portion of the electron source layer 3, source and drain electrodes S and D being ohmicly connected with the channel layer 2 through a pair of alloyed regions 4.

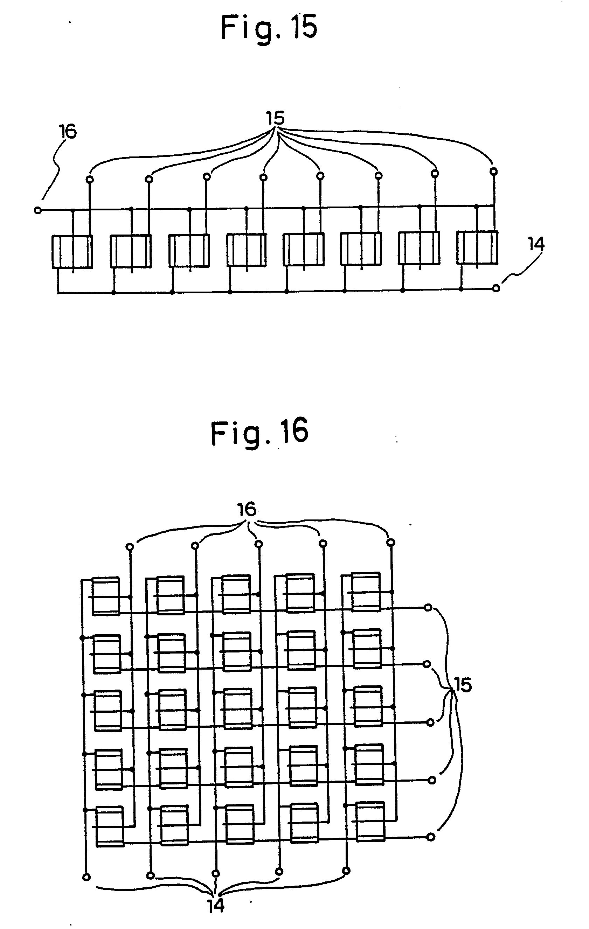

As described earlier, once this element is exposed to electromagnetic waves, e.g. light, at a cryogenic temperature, a two-dimensional electron gas 9 accumulates along the heterojunction between the electron source layer 3 and the channel layer 2 and remains unvolatilised, unless the element is warmed far beyond 77°K. This means that this element can be utilised as an image sensor having a memory function. Therefore, an array or a matrix of a plurality of such elements, respectively illustrated in Figures 15 and 16, can act as equipment for sensing an image.

Referring to Figures 15 and 16, all the sources of the elements in one row (Figure 15) or in one column (Figure 16) are connected with one another to be connected to a terminal 14 which is a row output terminal (Figure 15) or a column output terminal (Figure 16). All the drains of the elements included one row in Figure 16 are connected with one another to be connected to a terminal 15 which is a row output terminal of the row. In Figure 15 the drains are connected to respective terminals 15. Therefore, addressing each element through the terminals 14 and the terminals 16 enables reproduction of an image. The function of the terminals 16 which connect all the gates of elements in the image sensor is to allow dispersal of two-dimensional electron gas, caused by the exposure of the image sensor to light, without increasing the temperature of the image sensor.

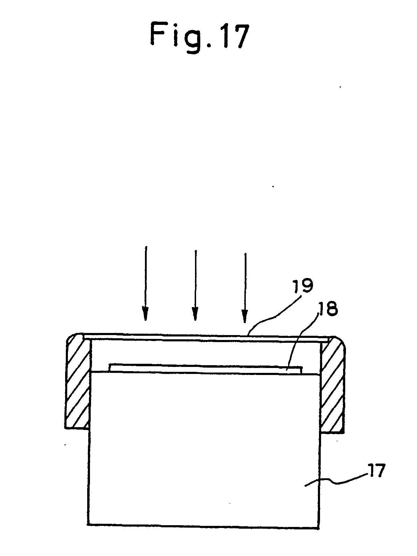

Figure 17 illustrates one example of the configuration of an image sensor in accordance with an embodiment of the present invention. In Figure 17, 17 is a cryogenic container which contains an array of matrix 18 of a plurality of image sensing elements each of which receives and senses light which has penetrated the container through a window or an optical system 19.

Needless to say, HEMTs provided with an insulated gate for the purpose of dispersing two-dimensional electron gas without increasing the temperature thereof can replace the HEMTs as mentioned above which are provided with a gate placed on a p type region produced in a limited upper region of the electron source layer.

Further, if a warming process is allowed for dispersion of the two-dimensional electron gas, high electron mobility heterojunction semiconductor devices provided with a pair of input/output electrodes but without a control electrode, or HEMTs from which the control electrodes are removed can replace either of the foregoing image sensing elements.

The foregoing description makes it clear that equipment for sensing an image, having a memory function and/or having large cross-sectional area, can be provided by embodiments of the present invention.

It will be understood that warming, application of positive voltage to a device control electrode, and exposure to electromagnetic waves of a wavelength corresponding approximately to the potential barrier between the electron source layer and the channel layer can provide modulation of the characteristics of a high electron mobility heterojunction semiconductor device by decreasing the surface concentration of the two-dimensional electron gas of the device.

Increase of such surface concentration, or restoration after decrease, is provided in embodiments of this invention by exposure to electromagnetic radiation.

**Claims**

1. A method of modifying characteristics of a high electron mobility heterojunction semiconductor device having an electron source layer and a channel layer, which method involves increasing the surface concentration of electrons which are accumulated along the heterojunction of the device, by exposing the device maintained at low temperatures to electromagnetic radiation, in order to induce a modification of characteristics of the device such as electrical conductivity, threshold voltage, saturated source current, the said modification being maintainable after the exposure so long as the device remains at low temperatures.

2. A method as claimed in claim 1, wherein a further modification of characteristics of the device is effected by warming the device.

3. A method as claimed in claim 2, comprising warming the device to a temperature in excess of 100K, preferably above 150K.

4. A method as claimed in claim 1, wherein a further modification of characteristics of the device is effected by exposing the device to further electromagnetic radiation.

5. A method as claimed in claim 3, comprising:

exposing the device to first electromagnetic radiation at a temperature not exceeding 150K; and

exposing the device to second electromagnetic radiation, having a wavelength longer than that of the first electromagnetic radiation at a temperature not exceeding 150K.

6. A method as claimed in claim 5, wherein the first electromagnetic radiation has a wavelength corresponding to the band gap of the electron source layer, or shorter, and the second electromagnetic radiation has a wavelength approximately corresponding to the potential barrier between the electron source layer and the channel layer.

7. A method as claimed in claim 1, wherein a further modification of characteristics of the device is effected by selective application of voltages to electrodes provided for the device.

8. A method as claimed in claim 7, the device being provided with an insulated gate-type control electrode through which the electromagnetic radiation can pass, comprising:

exposing the device to the electromagnetic radiation at a temperature not exceeding 150K; and

applying a voltage, positive when the electron source layer contains n-type impurities or contains no impurities from the practical point of view, to the control electrode, at a temperature not exceeding 150K.

9. A method as claimed in claim 8, wherein a negative voltage is applied to the control electrode during the exposure of the device to the electromagnetic radiation.

10. A method as claimed in claim 8 or 9, wherein the positive voltage applied to the control electrode is such as to provide a marginal modification of device characteristics.

11. A method as claimed in any one of claims 1 to 10, employing a laser as a source of electromagnetic radiation.

12. A method as claimed in claim 1, further comprising determining the condition of the device, as regards the surface concentration of electrons accumulated in a two-dimensional electron gas proximate the heterojunction of the device, characterised by determining the reflection coefficient of the device.

13. A method as claimed in claim 12, comprising irradiating the device with electromagnetic radiation of a wavelength such that the said surface concentration is not in substance affected thereby, and measuring the amount of such radiation reflected by the device.

14. A high electron mobility heterojunction semiconductor device, comprising a high electron mobility heterojunction semiconductor element having a pair of layers of which one is an electron source layer and the other, containing no impurities practically speaking and having an electron affinity larger than that of the electron source layer, is a channel layer, characterised in that at least a portion of the said pair of layers is arranged so as to be exposable to electromagnetic radiation, so that, by such exposure, the surface concentration of electrons which are accumulated along the heterojunction of the element is increased in order to induce a modification of characteristics of the element, such as electrical conductivity, threshold voltage, saturated source current, and in that a container contains the said pair of layers and is operable to maintain the contained layers at a temperature not exceeding 150K.

15. A device as claimed in claim 14, wherein the electron source layer contains n-type impurities.

16. A device as claimed in claim 14, wherein the electron source layer contains no impurities practically speaking.

17. A device as claimed in claim 14, 15 or 16, the said element being a high electron mobility transistor, the said pair of layers being grown on a semi-insulating semiconductor substrate, the element further comprising a control electrode, on the said pair of layers, such that electromagnetic radiation can pass therethrough, and an input electrode and an output electrode placed across the control electrode and on the said pair of layers, the control, input and output electrodes being contained within the container.

18. A device as claimed in claim 17, wherein the control electrode is a Schottky barrier gate-type electrode.

19. A device as claimed in claim 17, wherein the control electrode is an insulated gate-type electrode.

20. A device as claimed in claim 17, 18 or 19, wherein the electron source layer is grown on the channel layer and the control electrode is placed on a p-type well produced in an upper region of the electron source layer.

21. A device as claimed in claim 20, the element having a further control electrode, being a characteristics-modulation electrode, placed on the p-type well.

22. A device as claimed in claim 14, 15 or 16, being a passive device, having an opaque film provided to cover a portion of the said pair of layers to prevent exposure of that portion to electromagnetic radiation.

23. A device as claimed in claim 22, formed for acting as a connection channel or as an electrode of a capacitor.

24. A device as claimed in claim 15, or any one of claims 16 to 23 when read as appended to claim 15, further comprising a buffer layer, of an undoped semiconductor material identical to that of the electron source layer, between the electron source layer and the channel layer.

25. A device as claimed in any one of claims 14 to 24, further comprising radiation means operable to emit such electromagnetic radiation, those means being contained within the container.

26. A device as claimed in any one of claims 14 to 24, wherein the container has at least one transparent window which allows passage therethrough of such electromagnetic radiation, and the device further comprises radiation means operable to emit such electromagnetic radiation, those means being disposed outside the container in a position facing the transparent window.

27. A device as claimed in any one of claims 14 to 26, further comprising means operable to warm the said pair of layers.

28. A device as claimed in claims 25 or 26, further comprising a regulator operable to cause said radiation means to emit such electromagnetic radiation at predetermined intervals.

29. A device as claimed in claim 14, being a programmable memory device, including:

a plurality of such high electron mobility heterojunction semiconductor elements which are insulated from one another, the pair of layers of each element being grown on a semi-insulating semiconductor substrate, and an input electrode and an output electrode being placed on the said pair of layers apart from one another;

a plurality of radiation means operable to emit electromagnetic radiation, each such means being arranged for irradiating a corresponding one of the high electron mobility heterojunction semiconductor elements of the device;

the container containing the plurality of high electron mobility heterojunction semiconductor elements and being operable to maintain the elements at a temperature not exceeding 150K.

30. A device as claimed in claim 29, wherein each of the elements is a high electron mobility transistor, and each has an insulated gate-type control electrode, on the said pair of layers, such that electromagnetic radiation can pass therethrough, the input electrode and the output electrode of the element being placed across the control electrode, each of the radiation means being operable for irradiating the insulated gate-type control electrode of the corresponding element.

31. A device as claimed in claim 29, wherein each of the elements is a high electron mobility transistor, and each has a control gate, placed on a p-type well produced in an upper region of the electron source layer, such that electromagnetic radiation can pass therethrough, the input electrode and the output electrode of the element being placed across the control gate, each of the radiation means being operable for irradiating the control gate of the corresponding element.

32. A device as claimed in any one of claims 29, 30 and 31, wherein the electron source layer of each high electron mobility heterojunction semiconductor element contains n-type impurities.

33. A device as claimed in claim 32, wherein each high electron mobility heterojunction semiconductor element further comprises a buffer layer, of an undoped semiconductor material identical to that of the electron source layer, between the electron source layer and the channel layer.

34. A device as claimed in any one of claims 29, 30 and 31, wherein the electron source layer of each high electron mobility heterojunction semiconductor element contains no impurities practically speaking.

35. A device as claimed in any one of claims 29 to 34, including a regulator operable to cause each of the radiation means to emit electromagnetic radiation at predetermined intervals.

36. A device as claimed in any one of claims 29 to 35, further including means operable to warm the high electron mobility heterojunction semiconductor elements.

37. A device as claimed in any one of claims 29 to 36, wherein the plurality of high electron mobility heterojunction semiconductor elements constitute a matrix, all of the input electrodes of the high electron mobility heterojunction semiconductor elements constituting a row of the matrix being connected with one another to provide a bit line of the row, and all of the output electrodes of the high electron mobility heterojunction semiconductor elements constituting a column of the matrix being connected with one another to provide a word line of the column.

38. A device as claimed in claim 14, being a programmable memory device comprising:

a plurality of such elements, as memory elements, which are insulated from one another, the pair of layers of each element being grown on a semi-insulating semiconductor substrate;

means operable to emit first electromagnetic radiation for irradiating any selected one of the memory elements, for writing information;

means operable to emit second electromagnetic radiation, having a wavelength longer than that of the first electromagnetic radiation, and operable to irradiate each of the memory elements in progression, for reading information;

a plurality of means sensitive to the second electromagnetic radiation, each operable to sense reflected radiation from a corresponding one of the plurality of memory elements; and

the container containing at least the said plurality of memory elements and being operable to maintain the said plurality of memory elements at a temperature not exceeding 150K.

39. A device as claimed in claim 14, being a device for sensing an image, comprising:

a plurality of such elements as image sensing elements, which are insulated from one another and each of which is exposable to electromagnetic radiation the said pair of layers of each element being grown on a semi-insulating semiconductor substrate, and an input electrode and an output electrode being placed on the said pair of layers; and

the container containing the said plurality of image sensing elements and being operable to maintain the said plurality of image sensing elements at a temperature not exceeding 150K.

40. A device as claimed in claim 39, wherein the said plurality of image sensing elements constitutes a matrix, all of the input electrodes of the image sensing elements constituting a row of the matrix being connected with one another to be connected with an output terminal of the row, and all of the output electrodes of the image sensing elements constituting a column of the matrix being connected with one another to be connected with an output terminal of the column.

41. A device as claimed in claims 38, 39 or 40, wherein the electron source layer of each element contains n-type impurities.

42. A device as claimed in claim 41, wherein each element further comprises a buffer layer, of an undoped semiconductor material identical to that of the electron source layer, between the electron source layer and the channel layer.

43. A device as claimed in claim 38, 39 or 40, wherein the electron source layer of each element contains no impurities practically speaking.

44. A device as claimed in any one of claims 38 to 43, further comprising means operable to warm the elements.

45. A device as claimed in any one of claims 38 to 44, wherein each element is provided with an insulated gate-type control electrode.

46. A device as claimed in any one of claims 38 to 45, wherein the electron source layer of each element is grown on the channel layer of the element, and each element is provided with a p-type well region produced in a restricted upper region of its electron source layer.


**Patentansprüche**

1. Verfahren zum Modifizieren der Charakteristiken einer Halbleitervorrichtung mit hoher Elektronenmobilität und Heteroübergang, welche eine Elektronensourceschicht und eine Kanalschicht hat, welches Verfahren die Erhöhung der Oberflächenkonzentration von Elektronen umfaßt, die längs dem Heteroübergang der Vorrichtung akkumuliert werden, indem die Vorrichtung, während sie bei niedrigen Temperaturen gehalten wird, einer elektromagnetischen Strahlung exponiert wird, um eine Modifikation der Charakteristiken der Vorrichtung, wie elektrische Leitfähigkeit, Schwellenwertspannung, gesättigter Quellenstrom, zu induzieren, wobei die genannten Modifikationen nach der Exponierung solange aufrechterhaltbar sind, wie die Vorrichtung bei niedrigen Temperaturen verbleibt.

2. Verfahren nach Anspruch 1, bei dem die weitere Modifikation von Charakteristiken der Vorrichtung durch Erwärmen der Vorrichtung bewirkt wird.

3. Verfahren nach Anspruch 2, bei dem die Vorrichtung auf eine Temperatur oberhalb von 100K vorzugsweise oberhalb 150K erwärmt wird.

4. Verfahren nach Anspruch 1, bei dem eine weitere Modifikation von Charakteristiken der Vorrichtung durch Exponieren der Vorrichtung gegenüber weiterer elektromagnetischer Strahlung bewirkt wird.

5. Verfahren nach Anspruch 3, ferner mit:

Exponieren der Vorrichtung gegenüber einer ersten elektromagnetischen Strahlung bei einer Raumtemperatur nicht oberhalb 150K; und

Exponieren der Vorrichtung gegenüber einer zweiten elektromagnetischen Strahlung, welche eine Wellenlänge hat, die länger als diejenige der ersten elektromagnetischen Strahlung ist, bei einer Temperatur nicht oberhalb von 150K.

6. Verfahren nach Anspruch 5, bei dem die erste elektromagnetische Strahlung eine Wellenlänge hat, die dem Bandabstand der Elektronensourceschicht entspricht, oder kürzer ist, und die zweite elektromagnetische Strahlung eine Wellenlänge hat, die ungefähr der Potentialbarriere zwischen der Elektronensourceschicht und der Kanalschicht entspricht.

7. Verfahren nach Anspruch 1, bei dem eine weitere Modifikation der Charakteristiken der Vorrichtung

durch selektive Anwendung von Spannungen auf Elektroden, die für die Vorrichtung vorgesehen sind, bewirkt wird.

8. Verfahren nach Anspruch 7, bei dem die Vorrichtung mit einer Steuerelektrode vom isolierten Gate-Typ versehen ist, durch welche die elektromagnetische Strahlung hindurchgelangen kann, mit:

Exponieren der Vorrichtung gegenüber einer elektromagnetischen Strahlung bei einer Temperatur nicht oberhalb 150K; und

Anwenden einer Spannung, positiv wenn die Elektronensourceschicht n-Typ-Verunreinigungen oder von einem praktischen Gesichtspunkt aus keine Verunreinigungen enthält, um die Elektrode zu steuern, bei einer Temperatur nicht oberhalb 150K.

9. Verfahren nach Anspruch 8, bei dem eine negative Spannung auf die Steuerelektrode aufgebracht wird, während die Vorrichtung der elektromagnetischen Strahlung exponiert ist.

10. Verfahren nach Anspruch 8 oder 9, bei dem die positive Spannung, die auf die Steuerelektrode aufgebracht wird, derart ist, daß sie eine marginale Modifikation der Vorrichtungscharakteristiken liefert.

11. Verfahren nach einem der Ansprüche 1 bis 10, unter Verwendung eines Lasers als Quelle der elektromagnetischen Strahlung.

12. Verfahren nach Anspruch 1, ferner mit dem Bestimmen des Zustands der Vorrichtung, in Bezug auf die Oberflächenkonzentration von Elektronen, die in einem zweidimensionalen Elektronengas nahe der Heterogrenzschicht der Vorrichtung akkumuliert sind, gekennzeichnet durch Bestimmen des Reflektionskoeffizienten der Vorrichtung.

13. Verfahren nach Anspruch 12, mit Bestrahlen der Vorrichtung mit elektromagnetischer Strahlung von einer solchen Wellenlänge, daß die genannte Oberflächenkonzentration dadurch nicht in der Substanz beeinträchtigt wird, und Messen des Betrages von solcher Strahlung, die von der Vorrichtung reflektiert wird.

14. Halbleitervorrichtung mit hoher Elektroenmobilität und Heteroübergang, mit einem Heteroübergangs-Halbleiterelement hoher Elektronenmobilität, welches ein Paar von Schichten hat, von denen eine eine Elektronensourceschicht ist, und die andere, die praktisch gesprochen keine Verunreinigungen enthält und eine Elektronenaffinität größer als jene der Elektronensourceschicht hat, eine Kanalschicht ist, dadurch gekennzeichnet, daß wenigstens ein Teil des genannten Paares von Schichten so angeordnet ist, daß er der elektromagnetischen Strahlung exponierbar ist, so daß, durch die Bestrahlung, die Oberflächenkonzentration der Elektronen, die längs der Heterogrenzschicht des Elementes akkumuliert sind, erhöht werden kann, um eine Modifikation von Charakteristiken des Elementes, wie elektrische Leitfähigkeit, Schwellenwertspannung, Sättigungssourcestrom, zu induzieren, und daß ein Behälter des genannte Paar von Schichten enthält und betreibbar ist, um die enthaltenen Schichten bei einer Temperatur nicht oberhalb 150K zu halten.

15. Vorrichtung nach Anspruch 14, bei der die Elektronensource n-Typ-Verunreinigungen enthält.

16. Vorrichtung nach Anspruch 14, bei der die Elektronensourceschicht praktisch gesprochen keine Verunreinigungen enthält.

17. Vorrichtung nach Anspruch 14, 15 oder 16, bei der das genannte Element ein Transistor hoher Elektronenmobilität ist, das genannte Paar von Schichten auf einem halbisolierenden Halbleitersubstrat gewachsen ist, das Element ferner eine Steuerelektrode umfaßt, auf dem genannten Paar von Schichten, so daß elektromagnetische Strahlung hindurchgelangen kann und eine Eingangselektrode und eine Ausgangselektrode quer an der Steuerelektrode und an dem genannten Paar von Schichten plaziert sind, wobei die Steuer-, Eingangs- und Ausgangselektroden in dem Behälter enthalten sind.

18. Vorrichtung nach Anspruch 17, bei dem die Steuerelektrode eine Elektrode vom Schottky-Sperrschicht-Gate-Typ ist.

19. Vorrichtung nach Anspruch 17, bei der die Steuerelektrode eine Elektrode vom isolierten Gate-Typ ist.

20. Vorrichtung nach Anspruch 17, 18 oder 19, bei der die Elektronensourceschicht auf die Kanalschicht aufgewachsen ist und die Steuerelektrode auf einem p-Typ-Graben plaziert ist, der in einem oberen Bereich der Elektronensourceschicht erzeugt ist.

21. Vorrichtung nach Anspruch 20, bei der das Element eine weitere Steuerelektrode hat, welche eine Charakteristiken-Modulationselektrode ist, die auf dem p-Typ-Graben plaziert ist.

22. Vorrichtung nach Anspruch 14, 15 oder 16, welche eine passive Vorrichtung ist, die einen undurchlässigen Film hat, der vorgesehen ist, um einen Abschnitt des genannten Paares von Schichten zu bedecken, um eine Exponierung dieses Abschnitts gegenüber elektromagnetischer Strahlung zu verhindern.

23. Vorrichtung nach Anspruch 22, gebildet als oder wirkend als Verbindungskanal oder als eine Elektrode eines Kondensators.

24. Vorrichtung nach Anspruch 15 oder einem der Ansprüche 16 bis 23, in Verbindung mit Anspruch 15, ferner mit einer Pufferschicht, aus nichtdotiertem Halbleitermaterial, welches identisch zu jenem der Elektronensourceschicht ist, zwischen der Elektronensourceschicht und der Kanalschicht.

25. Vorrichtung nach einem der Ansprüche 14 bis 24, ferner mit Strahlungseinrichtungen, die betreibbar sind, um solche elektromagnetische Strahlung zu emittieren, wobei jene Einrichtungen in dem genannten Behälter enthalten sind.

26. Vorrichtung nach einem der Ansprüche 14 bis 24, bei der der Behälter wenigstens ein transparentes Fenster hat, welches solche elektromagnetische Strahlung hindurchtreten läßt, und die Vorrichtung ferner Strahlungseinrichtungen umfaßt, die betreibbar sind, um solche elektromagnetische Strahlung zu emittieren, wobei jene Einrichtungen an der Außenseite des Behälters in einer Position angeordnet sind, welche dem transparenten Fenster zugewandt ist.

27. Vorrichtung nach einem der Ansprüche 14 bis 26, ferner mit Einrichtungen, welche betreibbar sind, um das Paar von Schichten zu erwärmen.

28. Vorrichtung nach Anspruch 25 oder 26, ferner mit einem Regulator, der betreibbar ist, um zu bewirken, daß die genannte Strahlungseinrichtung solche elektromagnetische Strahlung bei vorbestimmten Intervallen emittiert.

29. Vorrichtung nach Anspruch 14, welche eine programmierbare Speichervorrichtung ist, mit:

einer Vielzahl von solchen Halbleiterelementen mit Heterogrenzschicht und hoher Elektronenmobilität, welche Elemente voneinander isoliert sind, wobei das Paar von Schichten von jedem Element auf einem halbisolierenden Halbleitersubstrat aufgewachsen ist, und eine Eingangselektrode und eine Ausgangselektrode auf dem genannten Paar von Schichten mit Abstand voneinander plaziert sind;

einer Vielzahl von Strahlungseinrichtungen, die betreibbar sind, um elektromagnetische Strahlung zu emittieren, wobei jede solche Einrichtung angeordnet ist, um ein entsprechendes der Halbleiterelemente mit hoher Elektronenmobilität und Heterogrenzschicht der Vorrichtung zu bestrahlen;

wobei der Behälter die Vielzahl von Halbleiterelementen mit hoher Elektronenmobilität und Heterogrenzschicht enthält und betreibbar ist, um die Elemente bei einer Temperatur zu halten, die 150K nicht überschreitet.

30. Vorrichtung nach Anspruch 29, bei der jedes der Elemente ein Transistor hoher Elektronenmobilität ist, und jedes eine Steuerelektrode vom isolierten Gate-Typ hat, auf dem genannten Paar von Schichten, so daß elektromagnetische Strahlung hindurchtreten kann, wobei die Eingangselektrode und die Ausgangselektrode des Elementes quer über der Steuerelektrode plaziert sind, jede der Strahlungseinrichtungen betreibbar ist, um die Steuerelektrode vom isolierten Gate-Typ des entsprechenden Elementes zu bestrahlen.

31. Vorrichtung nach Anspruch 29, bei der jedes der Elemente ein Transistor hoher Elektronenmobilität ist, und jeweils ein Steuergate hat, das auf einem p-Typ-Graben plaziert ist, der in einem oberen Bereich der Elektronensourceschicht erzeugt ist, so daß elektromagnetische Strahlung hindurchgelangen kann, die Eingangselektrode und die Ausgangselektrode des Elementes quer an dem Steuergate plaziert sind, jede der Strahlungseinrichtungen betreibbar ist, um das Steuergate des entsprechenden Elementes zu bestrahlen.

32. Vorrichtung nach einem der Ansprüche 29, 30 und 31, bei der die Elektronensourceschicht von jedem Halbleiterelement hoher Elektronenmobilität und mit Heterogrenzschicht n-Typ-Verunreinigungen enthält.

33. Vorrichtung nach Anspruch 32, bei der jedes Halbleiterelement mit hoher Elektronenmobilität und Heterogrenzschicht ferner eine Pufferschicht umfaßt, aus nichtdotiertem Halbleitermaterial, welches identisch mit jenem der Elektronensourceschicht ist, zwischen der Elektronensourceschicht und der Kanalschicht.

34. Vorrichtung nach einem der Ansprüche 29, 30 und 31, bei der die Elektronensourceschicht von jedem Halbleiterelement mit hoher Elektronenmobilität und Heterogrenzschicht praktisch gesprochen keine Verunreinigungen enthält.

35. Vorrichtung nach einem der Ansprüche 29 bis 34, mit einem Regulator, der betreibbar ist, um zu bewirken, daß jede der Strahlungseinrichtung bei vorbestimmten Intervallen elektromagnetische Strahlung emittiert.

36. Vorrichtung nach einem der Ansprüche 29 bis 35, ferner mit Einrichtungen, die betreibbar sind, um die Halbleiterelemente hoher Elektronenmobilität und mit Heterogrenzschicht zu erwärmen.

37. Vorrichtung nach einem der Ansprüche 29 bis 36, bei der die Vielzahl von Halbleiterelementen mit hoher Elektronenmobilität und Heterogrenzschicht eine Matrix bilden, alle Eingangselektroden der Halbleiterelemente mit hoher Elektronenmobilität und Heterogrenzschicht, eine Reihe der Matrix bilden, miteinander verbunden sind, um eine Bitleitung der Reihe zu bilden, und alle Ausgangselektroden der Halbleiterelemente mit hoher Elektronenmobilität und Heterogrenzschicht, die eine Spalte der Matrix bilden, miteinander verbunden sind, um eine Wortleitung der Spalte zu bilden.

38. Vorrichtung nach Anspruch 14, welche eine programmierbare Speichervorrichtung ist, mit:

einer Vielzahl von solchen Elementen, wie Speicherelementen, die voneinander isolierte sind, wobei das Paar von Schichten von jedem Element auf ein halbisolierendes Halbleitersubstrat aufgewachsen ist;

Einrichtungen, die betreibbar sind, um erste elektromagnetische Strahlung zur Bestrahlung irgendwelcher ausgewählter der Speicherelemente zu emittieren, um Information zu schreiben;

Einrichtungen, die betreibbar sind, um zweite elektromagnetische Strahlung zu emittieren, welche eine Wellenlänge hat, die länger als diejenige der ersten elektromagnetischen Strahlung ist, und betreibbar, um jedes der Speicherelemente fortschreitend zu bestrahlen, um Information zu lesen;

einer Vielzahl von Einrichtungen, die gegenüber der zweiten elektromagnetischen Strahlung empfindlich sind, wobei jede betreibbar ist, um von einem entsprechenden der Vielzahl von Speicherelementen reflektierte Strahlung zu fühlen; und

der Behälter wenigstens die genannte Vielzahl von Speicherelementen enthält und betreibbar ist, um die genannte Vielzahl von Speicherelementen bei einer Temperatur zu halten, die 150K nicht überschreitet.

39. Vorrichtung nach Anspruch 14, welche eine Vorrichtung zum Fühlen eines Bildes ist, mit:

einer Vielzahl von solchen Elementen als Bildfühlelemente, welche voneinander isoliert sind und von denen jedes elektromagnetischer Strahlung exponierbar ist, wobei das genannte Paar von Schichten von jedem Element, das auf einem halbisolierenden Halbleiterelement aufgewachsen ist, und eine Eingangselektrode und eine Ausgangselektrode auf dem genannten Paar von Schichten plaziert sind; und

der Behälter die genannte Vielzahl von Bildfühlelementen enthält und betreibbar ist, um die genannte Vielzahl von Bildfühlelementen bei einer Temperatur zu halten, die 150K nicht überschreitet.

40. Vorrichtung nach Anspruch 39, bei der die genannte Vielzahl von Bildfühlelementen eine Matrix bildet, alle Eingangselektroden der Bildfühlelemente, die eine Reihe der Matrix bilden, miteinander verbunden sind, um mit einem Ausgangsanschluß der Reihe verbunden zu werden, und alle Ausgangselektroden der Bildfühlelemente, die eine Spalte der Matrix bilden, miteinander verbunden sind, um mit einem Ausgangsanschluß der Spalte verbunden zu werden.

41. Vorrichtung nach Anspruch 38, 39 oder 40, bei der die Elektronensourceschicht von jedem Element n-Typ-Verunreinigungen enthält.

42. Vorrichtung nach Anspruch 41, bei der jedes Element ferner eine Pufferschicht umfaßt, aus nichtdotiertem Halbleitermaterial, welches, identisch mit jenem der Elektronensourceschicht ist, zwischen der Elektronensourceschicht und der Kanalschicht.

43. Vorrichtung nach Anspruch 38, 39 oder 40, bei der die Elektronensourceschicht von jedem Element praktisch gesprochen keine Verunreinigungen enthält.

44. Vorrichtung nach einem der Ansprüche 38 bis 43, ferner mit Einrichtungen, die betreibbar sind, um die Elemente zu erwärmen.

45. Vorrichtung nach einem der Ansprüche 38 bis 44, bei der jedes Element mit einer Steuerelektrode vom isolierten Gate-Typ versehen ist.

46. Vorrichtung nach einem der Ansprüche 38 bis 45, bei der die Elektronensourceschicht von jedem Element auf der Kanalschicht des Elements aufgewachsen ist, und jedes Element mit einem p-Typ-Grabenbereich versehen ist, der in einem beschränkten oberen Bereich seiner Elektronensourceschicht erzeugt ist.

## Revendications

1. Un procédé de modification de caractéristiques d'un dispositif à semiconducteurs à hétérojonction et à mobilité électronique élevée, comportant une couche de source d'électrons et une couche de canal, ce procédé comprenant l'augmentation de la concentration de surface d'électrons qui sont accumulés le long de l'hétérojonction du dispositif, par l'exposition du dispositif à un rayonnement électromagnétique, alors que le dispositif est maintenu à de basses températures, dans le but d'induire une modification de caractéristiques du didpositif telles que la conductivité électrique, la tension de seuil, le courant de source à l'état saturé, cette modification pouvant se maintenir après l'exposition, aussi longtemps que le dispositif reste à de basses températures.

2. Un procédé selon la revendication 1, dans lequel une modification supplémentaire de caractéristiques du dispositif est effectuée en réchauffant le dispositif.

3. Un procédé selon la revendication 2, comprenant le réchauffement du dispositif jusqu'à une température supérieure à 100 K, et de préférence supérieure à 150 K.

4. Un procédé selon la revendication 1, dans lequel une modification supplémentaire de caractéristiques du dispositif est effectuée en exposant le dispositif à un rayonnement électromagnétique supplémentaire.

5. Un procédé selon la revendication 3, comprenant les opérations suivantes:

on expose le dispositif à un premier rayonnement électromagnétique à une température ne dépassant pas 150 K; et

on expose le dispositif à un second rayonnement électromagnétique, ayant une longueur d'onde supérieure à celle du premier rayonnement électromagnétique, à une température ne dépassant pas 150 K.

6. Un procédé selon la revendication 5, dans lequel le premier rayonnement électromagnétique a une longueur d'onde correspondant à la bande interdite de la couche de source d'électrons, ou une longueur d'onde inférieure, et le second rayonnement électromagnétique a une longueur d'onde correspondant approximativement à la barrière de potentiel entre la couche de source d'électrons et la couche de canal.

7. Un procédé selon la revendication 1, dans lequel une modification supplémentaire de caractéristiques du dispositif est effectuée par l'application sélective de tensions à des électrodes qui sont établies pour le dispositif.

8. Un procédé selon la revendication 7, applicable dans le cas où le dispositif comporte une électrode de commande du type grille isolée à travers laquelle le rayonnement électromagnétique peut passer, comprenant les opérations suivantes:

on expose le dispositif au rayonnement électromagnétique à une température ne dépassant pas 150 K; et

on applique à l'électrode de commande une tension positive, lorsque la couche de source d'électrons contient des impuretés de type n ou ne contient pas d'impuretés d'un point de vue pratique, à une température ne dépassant pas 150 K.

9. Un procédé selon la revendication 8, dans lequel une tension négative est appliquée à l'électrode de commande pendant l'exposition du dispositif au rayonnement électromagnétique.

10. Un procédé selon la revendication 8 ou 9, dans lequel la tension positive qui est appliquée à l'électrode de commande est telle qu'elle produit une modification marginale de caractéristiques du dispositif.

11. Un procédé selon l'une quelconque des revendications 1 à 10, employant un laser à titre de source de rayonnement électromagnétique.

12. Un procédé selon la revendication 1, comprenant en outre la détermination de l'état du dispositif, en ce qui concerne la concentration de surface d'électrons accumulés dans un gaz d'électrons bidimensionnel à proximité de l'hétérojonction du dispositif, caractérisé par la détermination du coefficient de réflexion du dispositif.

13. Un procédé selon la revendication 12, comprenant l'irradiation du dispositif avec un rayonnement électromagnétique d'une longueur d'onde telle que la concentration de surface ne soit pas notablement affectée par ce rayonnement, et la mesure de la fraction de ce rayonnement qui est réfléchie par le dispositif.

14. Un dispositif à semiconducteur à hétérojonction et à mobilité électronique élevée, comprenant un élément à semiconducteurs à hétérojonction et à mobilité électronique élevée ayant une paire de couches dont l'une est une couche de source d'électrons et l'autre, ne contenant pratiquement pas d'impuretés et ayant une affinité électronique supérieure à celle de la couche de source d'électrons, est une couche de canal, caractérisé en ce qu'au moins une partie de cette paire de couches est conçue de façon à pouvoir être exposée à un rayonnement électromagnétique, de façon que, sous l'effet de cette exposition, la concentration de surface d'électrons qui sont accumulés le long de l'hétérojonction de l'élément soit augmentée, dans le but d'induire une modification de caractéristiques de l'élément, telles que la conductivité électrique, la tension de seuil ou le courant de source à l'état saturé, et en ce qu'une enceinte contient la paire de couches précitée et est capable de maintenir les couches se trouvant à l'intérieur à une température ne dépassant pas 150 K.

15. Un dispositif selon la revendication 14, dans lequel la couche de source d'électrons contient des impuretés de type n.

16. Un dispositif selon la revendication 14, dans lequel la couche de source d'électrons ne contient pratiquement pas d'impuretés.

17. Un dispositif selon la revendication 14, 15 ou 16, dans lequel l'élément précité est un transistor à mobilité électronique élevée, la paire de couches est formée par croissance sur un substrat semiconducteur semi-isolant, et l'élément comprend en outre une électrode de commande, sur la paire de couches précitée, cette électrode étant conçue de façon qu'un rayonnement électromagnétique puisse la traverser, et une électrode d'entrée et une électrode de sortie qui sont placées de part et d'autre de l'électrode de commande, et sur la paire de couches, les électrodes de commande, d'entrée et de sortie se trouvant à l'intérieur de l'enceinte.

18. Un dispositif selon la revendication 17, dans lequel l'électrode de commande est une électrode du type grille à barrière de Schottky.

19. Un dispositif selon la revendication 17, dans lequel l'électrode de commande est une électrode du type grille isolée.

20. Un dispositif selon la revendication 17, 18 ou 19, dans lequel la couche de source d'électrons est formée par croissance sur la couche de canal, et l'électrode de commande est placée sur un puits de type p qui est formé dans une région supérieure de la couche de source d'électrons.

21. Un dispositif selon la revendication 20, dans lequel l'élément comporte une électrode de commande supplémentaire, qui est une électrode de modulation de caractéristiques, placée sur le puits de type p.

22. Un dispositif selon la revendication 14, 15 ou 16, qui consiste en un dispositif passif, comportant une pellicule opaque formée de façon à recouvrir une partie de la paire de couches précitée, afin d'empêcher l'exposition de cette partie à un rayonnement électromagnétique.

23. Un dispositif selon la revendication 22, formé par remplir la fonction d'un canal de connexion ou d'une électrode d'un condensateur.

24. Un dispositif selon la revendication 15, ou l'une quelconque des revendications 16 à 23, lorsqu'on considère qu'elles sont rattachées à la revendication 15, comprenant en outre une couche tampon, en un matériau semiconducteur non dopé identique à celui de la source de source d'électrons, entre la couche de source d'électrons et la couche de canal.

25. Un dispositif selon l'une quelconque des revendications 14 à 24, comprenant en outre des moyens d'émission de rayonnement qu'on peut faire fonctionner de façon à émettre le rayonnement électromagnétique précité, ces moyens se trouvant à l'intérieur de l'enceinte.

26. Un dispositif selon l'une quelconque des revendications 14 à 24, dans lequel l'enceinte comporte au moins une fenêtre transparent qui permet le passage d'un tel rayonnement électromagnétique, et le dispositif comprend en outre des moyens d'émission de rayonnement qu'on peut faire fonctionner de façon à émettre un tel rayonnement électromagnétique, ces moyens se trouvant à l'extérieur de l'enceinte, face à la fenêtre transparente.

EP 0 060 657 B1

27. Un dispositif selon l'une quelconque des revendications 14 à 26, comprenant en outre des moyens qu'on peut faire fonctionner pour réchauffer la paire de couches.

28. Un dispositif selon les revendications 25 ou 26, comprenant en outre un régulateur qu'on peut faire fonctionner de manière que les moyens d'émission de rayonnement émettent un tel rayonnement électromagnétique à des intervalles prédéterminés.

29. Un dispositif selon la revendication 14, qui consiste en un dispositif de mémoire programmable, comprenant:

un ensemble de tels éléments semiconducteurs à hétérojonction et à mobilité électronique élevée, qui sont mutuellement isolés, la paire de couches de chaque élément étant formée par croissance sur un substrat semiconducteur semi-isolant, et une électrode d'entrée et une électrode de sortie étant placées sur la paire de couches, en étant mutuellement espacées;

un ensemble de moyens d'émission de rayonnement, qu'on peut faire fonctionner de façon à émettre un rayonnement électromagnétique, chacun de ces moyens étant conçu pour irradier l'un correspondant des éléments à semiconducteurs à hétérojonction et à mobilité électronique élevée du dispositif;

l'enceinte contenant l'ensemble d'éléments à semiconducteurs à hétérojonction et à mobilité électronique élevée, et étant capable de maintenir les éléments à une température ne dépassant pas 150 K.

30. Un dispositif selon la revendication 29, dans lequel chacun des éléments est un transistor à mobilité électronique élevée, et chacun d'eux comporte une électrode de commande du type grille isolée, sur la paire de couches précitée, cette électrode étant conçu de façon que le rayonnement électromagnétique puisse la traverser, l'électrode d'entrée et l'électrode sortie de l'élément étant placées de part et d'autre de l'électrode de commande, et chacun des moyens d'émission de rayonnement étant capable d'irradier l'électrode de commande du type grille isolée de l'élément correspondant.

31. Un dispositif selon la revendication 29, dans lequel chacun des éléments est un transistor à mobilité électronique élevée et chacun d'eux comporte une grille de commande, placée sur un puits de type p qui est formé dans une région supérieure de la couche de source d'électrons, de façon qu'un rayonnement électromagnétique puisse traverser cette grille de commande, l'électrode d'entrée et l'électrode de sortie de l'élément étant placées de part et d'autre de la grille de commande, et chacun des moyens d'émission de rayonnement étant capable d'irradier la grille de commande de l'élément correspondant.

32. Un dispositif selon l'une quelconque des revendications 29, 30 et 31, dans lequel la couche de source d'électrons de chaque élément à semiconducteurs à hétérojonction à mobilité électronique élevée contient des impuretés de type n.

33. Un dispositif selon la revendication 32, dans lequel chaque élément à semiconducteurs à hétérojonction et à mobilité électronique élevée comprend en outre une couche tampon, en un matériau semiconducteur non dopé identique à celui de la couche de source d'électrons, entre la couche de source d'électrons et la couche de canal.

34. Un dispositif selon l'une quelconque des revendications 29, 30 et 31, dans lequel la couche de source d'électrons de chaque élément à semiconducteur à hétérojonction et à mobilité électronique élevée ne contient pratiquement pas d'impuretés.

35. Un dispositif selon l'une quelconque des revendications 29 à 34, comprenant un régulateur qu'on peut faire fonctionner pour faire en sorte que chacun des moyens d'émission de rayonnement émette un rayonnement électromagnétique à des intervalles prédéterminés.

36. Un dispositif selon l'une quelconque des revendications 29 à 35, comprenant en outre des moyens qu'on peut faire fonctionner de façon à réchauffer les éléments à semiconducteurs à hétérojonction et à mobilité électronique élevée.

37. Un dispositif selon l'une quelconque des revendications 29 à 36, dans lequel l'ensemble d'éléments à semiconducteurs à hétérojonction et à mobilité électronique élevée constitue une matrice, toutes les électrodes d'entrée des éléments à semiconducteurs à hétérojonction et à mobilité électronique élevée qui forment une rangée de la matrice étant connectées les unes aux autres pour définir une ligne de bit de la rangée, et toutes les électrodes de sortie des éléments à semiconducteurs à hétérojonction et à mobilité électronique élevée qui forment une colonne de la matrice étant connectées les unes aux autres pour définir une ligne de mot de la colonne.

38. Un dispositif selon la revendication 14, qui consiste en un dispositif de mémoire programmable, comprenant:

un ensemble des éléments précités, constituant des éléments de mémoire, qui sont mutuellement isolés, la paire de couches de chaque élément étant formée par croissance sur un substrat semiconducteur semi-isolant;

des moyens qu'on peut faire fonctionner pour émettre un premier rayonnement électromagnétique, pour irradier n'importe quel élément sélectionné parmi les éléments de mémoire, pour écrire de l'information;

des moyens qu'on peut faire fonctionner pour émettre un second rayonnement électromagnétique, ayant une longueur d'onde supérieure à celle du premier rayonnement électromagnétique, et qu'on peut faire fonctionner pour irradier chacun des éléments de mémoire, en progressant d'un élément au suivant, pour lire de l'information;

un ensemble de moyens sensibles au second rayonnement électromagnétique, chacun d'eux étant capable de détecter le rayonnement réfléchi à partir d'un élément correspondant parmi l'ensemble d'éléments de mémoire; et

l'enceinte contenant au moins l'ensemble d'éléments de mémoire et étant capable de maintenir l'ensemble d'éléments de mémoire à une température ne dépassant pas 150 K.

39. Un dispositif selon la revendication 14, qui consiste en un dispositif destiné à détecter une image, comprenant:

un ensemble des éléments précités, constituant des éléments de détection d'image, qui sont mutuellement isolés, et chacun d'eux pouvant être exposé à un rayonnement électromagnétique, la paire de couches de chaque élément étant formée par croissance sur un substrat semiconducteur semi-isolant, et une électrode d'entrée et une électrode de sortie étant placées sur la paire de couches; et

l'enceinte contenant l'ensemble d'éléments de détection d'image et étant capable de maintenir l'ensemble d'éléments de détection d'image à une température ne dépassant pas 150 K;

40. Un dispositif selon la revendication 39, dans lequel l'ensemble l'éléments de détection d'image constitue une matrice, toutes les électrodes d'entrée des éléments de détection d'image qui constituent une rangée de la matrice étant connectées les unes aux autres, pour être connectées à une borne de sortie de la rangée, et toutes les électrodes de sortie des éléments de détection d'image qui constituent une colonne de la matrice étant connectées les unes aux autres pour être connectées à une borne de sortie de la colonne.

41. Un dispositif selon les revendications 38, 39 ou 40, dans lequel la couche de source d'électrons de chaque élément contient des impuretés de type n.

42. Un dispositif selon la revendication 41, dans lequel chaque élément comprend en outre une couche tampon, en un matériau semiconducteur non dopé identique à celui de la couche de source d'électrons, entre la couche de source d'électrons et la couche de canal.

43. Un dispositif selon la revendication 38, 39 ou 40, dans lequel la couche de source d'électrons de chaque élément ne contient pratiquement pas d'impuretés.

44. Un dispositif selon l'une quelconque des revendications 38 à 43, comprenant en outre des moyens qu'on peut faire fonctionner de façon à réchauffer les éléments.

45. Un dispositif selon l'une quelconque des revendications 38 à 44, dans lequel chaque élément comporte une électrode de commande du type grille isolée.

46. Un dispositif selon l'une quelconque des revendications 38 à 45, dans lequel la couche de source d'électrons de chaque élément est formée par croissance sur la couche de canal de l'élément, et chaque élément comporte une région de puits de type p qui est formée dans une région supérieure restreinte de sa couche de source d'électrons.

# Fig. 1

# Fig. 2

# Fig. 3

| | | | |
|---|---|---|---|
| 5 | 3′ | 6 | 10 | 5 |

n AlGaAs

i AlGaAs

i GaAs

GaAs sub

4 ... 4

2

1

9

# Fig. 4

| 5 | 3′ | 6 | 5 |

i AlGaAs

i GaAs

GaAs sub

4 ... 4

2

1

9

2

# Fig. 5

Electron Mobility (Cm²/Vs) vs Electron Concentration (Cm²)

# Fig. 6

# Fig. 7

# Fig. 8

4

# Fig. 9

# Fig. 10

# Fig. 11

$6'$ — $3$ — $2$

$13$

# Fig. 12

$13$  $3$  $13$  $3$  $13$

n AlGaAs

i GaAs  $2$

GaAs sub  $1$

## Fig. 13

## Fig. 14

# Fig. 15

# Fig. 16

# Fig.17